# EUROPEAN PATENT APPLICATION

(11) **EP 4 395 503 A1**
(43) Date of publication of application: **03.07.2024**
(21) Application number: 23214787.6
(22) Date of filing: 07.12.2023
(51) Int. Cl.: H10K 59/121, H10K 59/131, H10K 59/80

(54) **DISPLAY DEVICE**

(30) Priority: 30.12.2022 KR 20220191290
(71) Applicant: LG Display Co., Ltd., Seoul 07336 (KR)
(72) Inventor: CHO, Young Sung, 10845 Paju-si (KR); KIM, Ji Ah, 10845 Paju-si (KR); JO, Jae Gang, 10845 Paju-si (KR)
(74) Representative: Finlayson, Scott Henry

(57) **Abstract**

Embodiments of the disclosure relate to a display device. Specifically, there may be provided a display device capable of suppressing flare when a camera is used by including an anode extension line having a curved shape.

## Description

### CROSS-REFERENCE TO RELATED APPLICATION

This application claims priority from Korean Patent Application No. 10-2022-0191290, filed on December 30, 2022, which is hereby incorporated by reference for all purposes as if fully set forth herein.

### BACKGROUND

### Field

The present disclosure relates to a display device.

### Description of Related Art

With the development of technology, the display device may provide a capture function and various detection functions in addition to an image display function. To this end, the display device can include an optical electronic device (also referred to as a light receiving device or sensor), such as a camera and/or a detection sensor.

Since the optical electronic device receives light from the front of the display device, it should be installed where light reception is easy. Accordingly, conventionally, the camera (camera lens) and the detection sensor had to be installed to be exposed on the front surface of the display device. Thus, the bezel of the display panel is widened or a notch or physical hole is formed in the display area of the display panel, and a camera or a detection sensor is installed there.

Therefore, as the display device is equipped with optical electronic devices such as cameras, detection sensors, etc. that perform a specified function by receiving light from the front, the front of the display device may have a large bezel or the front design of the display device may be restricted.

### BRIEF SUMMARY

In the field of display technology, techniques are being researched to equip optical electronic devices such as cameras and detection sensors without reducing the area of the display area of the display panel. A display device may be provided having a light transmission structure in which an optical electronic device is provided under the display area of a display panel such that the optical electronic device may normally receive light without exposing the optical electronic device from the front of the display device. However, when the optical electronic device of such a display device is used, it may be difficult to smoothly receive light due to the line structure of the display device. In particular, when a camera is used under the display area, flare may occur due to the line structure of the display device. Accordingly, the inventors of the disclosure have invented a display device capable of suppressing flare even when the camera is used, while including a camera without reducing the area of the display area.

At its most general, the present disclosure provides a display device suitable for use with a camera, wherein the display device is arranged to effectively transmit light through an optical area thereof. The display device may in particular be capable of suppressing flare by including an anode extension line having a curved shape.

Examples of the disclosure provide a display device comprising a display area, a cathode electrode, a first light emitting element, a first subpixel circuit unit, and an anode extension line.

The display area may include a first optical area and a first optical bezel area. The first optical bezel area may be positioned outside the first optical area, for example surrounding the first optical area. The first optical area may be configured to transmit light therethrough. The first optical area may have a light transmittance that is higher than that of the first optical bezel area. The first optical bezel area may be configured not to transmit light therethrough. The display area may further comprise a normal area. The normal area may surround the first optical bezel area. Each of the normal area, the first optical area, and the first optical bezel area, may be configured to emit light, e.g. to display an image. That is, the first optical area, the first optical bezel area, and the normal area, may form a display area of the device. The normal area may be configured not to transmit light therethrough. A non-display area may be provided outside of (e.g. around an edge of) the display area. The non-display area may be configured not to emit light.

The cathode electrode may include a plurality of cathode holes in the first optical area. The cathode holes may comprise open holes which extend through the cathode, for transmission of light therethrough. The cathode may extend into the first optical bezel area and into the normal area, and may be free from cathode holes in the first optical bezel area and in the normal area.

The first light emitting element may be positioned in the first optical area and may include a first anode electrode. The first light emitting element may be an element, for example a pixel or sub-pixel, configured to emit light. The first light emitting element may define a corresponding emission area in the display device.

The first subpixel circuit unit may be positioned in the first optical bezel area. The first subpixel circuit unit may be a circuit configured to drive the first subpixel.

The anode extension line may electrically connect the first subpixel circuit unit to the first anode electrode. The anode extension line may be positioned not to overlap the cathode hole.

The anode extension line may have a curved shape.

The anode extension lines may extend in a first direction across the first optical area, and each anode extension line may terminate at its connection with its respective anode electrode.

The number of anode extension lines per unit area may decrease from an edge of the first optical area to a centre of the first optical area.

The plurality of anode extension lines may be divided into a plurality of groups, and the thickness of each of the plurality of groups may decrease from an edge of the first optical area to a centre of the first optical area.

An invention is defined in the appended claims.

### EFFECTS OF THE DISCLOSURE

According to the disclosure, there may be provided a display device capable of suppressing flare when used with a camera provided underneath the display device, by including an anode extension line having a curved shape.

According to the disclosure, there may be provided a display device process-optimized by forming an anode extension line without introducing an additional process.

### DESCRIPTION OF DRAWINGS

The above and other objects, features, and advantages of the disclosure will be more clearly understood from the following detailed description, taken in conjunction with the accompanying drawings, in which:
FIGS. 1A, 1B, and 1C illustrate a display device according to examples of the disclosure;
FIG. 2 is a view illustrating a configuration of a system of a display device according to examples of the disclosure;
FIG. 3 is a view schematically illustrating a display panel according to examples of the disclosure;
FIG. 4 schematically illustrates a normal area, a first optical bezel area, and a first optical area in a display panel according to examples of the disclosure;
FIGS. 5 and 6 illustrate a light emitting element and a subpixel circuit unit for driving the light emitting element, disposed in each of a normal area, a first optical bezel area, and a first optical area, according to examples of the disclosure;
FIG. 7 is a plan view illustrating a normal area, an optical bezel area, and an optical area in a display panel according to examples of the disclosure;
FIGS. 8 and 9 are cross-sectional views illustrating a first optical bezel area and a first optical area of a display panel according to examples of the disclosure;
FIG. 10 is a plan view illustrating a first optical area of a display device according to a comparative example of the disclosure;
FIG. 11 is a plan view illustrating a first optical area of a display device according to examples of the disclosure;
FIGS. 12 and 13 are enlarged plan views illustrating a partial area of the plan view of FIG. 11;
FIGS. 14 and 15 are views schematically illustrating a cross section of an anode extension line according to examples of the disclosure;
FIGS. 16, 17, and 18 are cross-sectional views illustrating a display device according to examples of the disclosure;
FIG. 19 is a view illustrating a flare suppression effect according to the shape of an anode extension line according to examples of the disclosure; and
FIG. 20 is a view illustrating a flare suppression effect according to the shape of an anode connection line according to examples of the disclosure.

### DETAILED DESCRIPTION

In the following description of examples or examples of the disclosure, reference will be made to the accompanying drawings in which it is shown by way of illustration specific examples that can be implemented, and in which the same reference numerals and signs can be used to designate the same or like components even when they are shown in different accompanying drawings from one another. Further, in the following description of examples of the disclosure, detailed descriptions of well-known functions and components incorporated herein will be omitted when it is determined that the description may make the subject matter in some examples of the disclosure rather unclear. The terms such as "comprising", "including", "having", "containing", "constituting" "make up of", and "formed of" used herein are generally intended to allow other components to be added unless the terms are used with the term "only". As used herein, singular forms are intended to include plural forms unless the context clearly indicates otherwise.

Terms, such as "first", "second", "A", "B", "(A)", or "(B)" may be used herein to describe elements of the disclosure. Each of these terms is not used to define essence, order, sequence, or number of elements etc., but is used merely at an arbitrary label to distinguish the corresponding element from other elements.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

When time relative terms, such as "after," "subsequent to," "next," "before," and the like, are used to describe processes or operations of elements or configurations, or flows or steps in operating, processing, manufacturing methods, these terms may be used to describe non-consecutive or non-sequential processes or operations unless the term "directly" or "immediately" is used together.

In addition, when any dimensions, relative sizes etc. are mentioned, it should be considered that numerical values for an elements or features, or corresponding information (e.g., level, range, etc.) include a tolerance or error range that may be caused by various factors e.g., process factors, internal or external impact, noise, etc.) even when a relevant description is not specified. Further, the term "may" fully encompasses all the meanings of the term "can".

Hereinafter, various examples of the disclosure are described in detail with reference to the accompanying drawings.

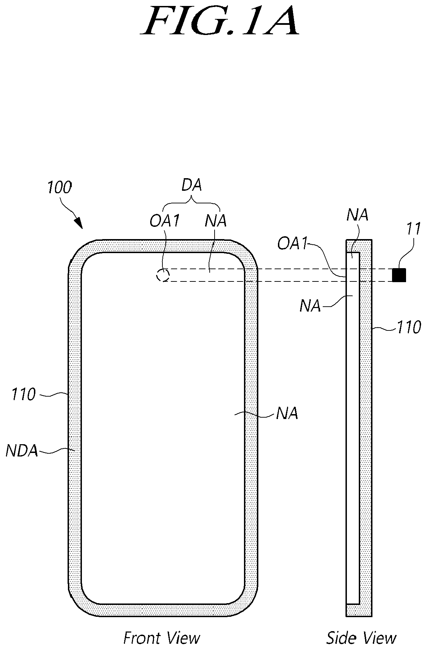

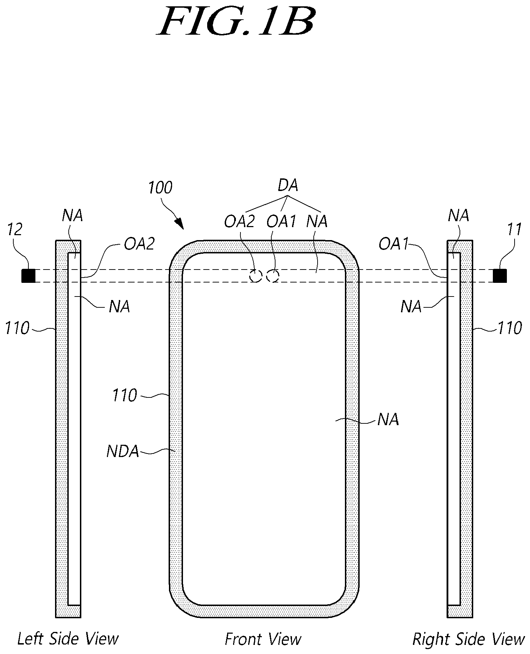

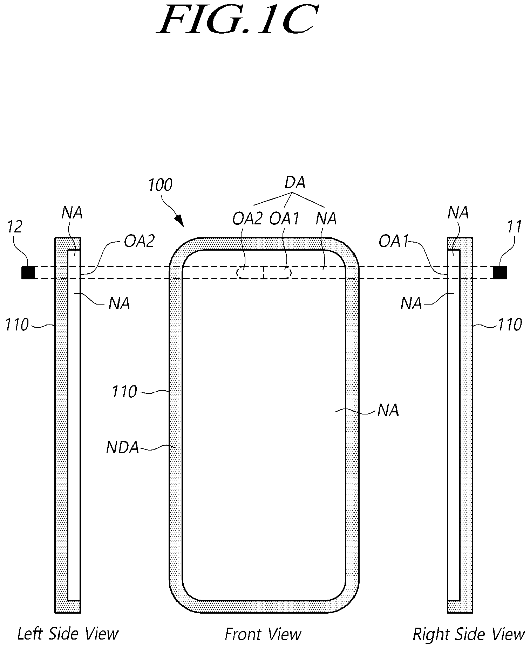

FIGS. 1A, 1B, and 1C illustrate a display device 100 according to examples of the disclosure.

Referring to FIGS. 1A, 1B, and 1C, a display device 100 according to examples of the disclosure may include a display panel 110 for displaying images and one or more optical electronic devices 11 and 12.

The display panel 110 may include a display area DA in which images are displayed and a non-display area NDA in which no image is displayed.

A plurality of subpixels may be disposed in the display area DA, and various signal lines for driving the plurality of subpixels may be disposed in the display area DA.

The non-display area NDA may be an area outside the display area DA. In the non-display area NDA, various signal lines may be disposed, and various driving circuits may be connected thereto. The non-display area NDA may be bent to be invisible from the front or may be covered by a case (not shown). The non-display area NDA is also referred to herein as a bezel or a bezel area.

Referring to FIGS. 1A, 1B, and 1C, in the display device 100 according to examples of the disclosure, one or more optical electronic devices 11 and 12 are electronic components that are provided and installed separately from the display panel 110 and positioned under the display panel 110 (side opposite to the viewing surface).

Light enters the front surface (viewing surface) of the display panel 110 and passes through the display panel 110 to one or more optical electronic devices 11 and 12 positioned under the display panel 110 (opposite to the viewing surface). For example, the light passing through the display panel 110 may include visible light, infrared light, or ultraviolet light.

The one or more optical electronic devices 11 and 12 may be devices that receive the light transmitted through the display panel 110 and perform a predetermined function according to the received light. For example, the one or more optical electronic devices 11 and 12 may include one or more of a capture device, such as a camera (image sensor), and a detection sensor, such as a proximity sensor and an illuminance sensor. For example, the detection sensor may be an infrared sensor.

Referring to FIGS. 1A, 1B, and 1C, in the display panel 110 according to examples of the disclosure, the display area DA may include a normal area NA and one or more optical areas OA1 and OA2. The one or more optical areas OA1 and OA2 may be areas overlapping the one or more optical electronic devices 11 and 12.

According to the example of FIG. 1A, the display area DA may include the normal area NA and the first optical area OA1. At least a portion of the first optical area OA1 may overlap the first optical electronic device 11.

According to the example of FIG. 1B, the display area DA may include a normal area NA, a first optical area OA1, and a second optical area OA2. In the example of FIG. 1B, the normal area NA may be present between the first optical area OA1 and the second optical area OA2. At least a portion of the first optical area OA1 may overlap the first optical electronic device 11, and at least a portion of the second optical area OA2 may overlap the second optical electronic device 12.

According to the example of FIG. 1C, the display area DA may include a normal area NA, a first optical area OA1, and a second optical area OA2. In the example of FIG. 1C, the normal area NA is not present between the first optical area OA1 and the second optical area OA2. In other words, the first optical area OA1 and the second optical area OA2 touch each other. At least a portion of the first optical area OA1 may overlap the first optical electronic device 11, and at least a portion of the second optical area OA2 may overlap the second optical electronic device 12.

The one or more optical areas OA1 and OA2 should have both an image display structure and a light transmission structure. In other words, since the one or more optical areas OA1 and OA2 are partial areas of the display area DA, emission areas of subpixels for displaying images should be disposed in the one or more optical areas OA1 and OA2. A light transmission structure for transmitting light to the one or more optical and electronic devices 11 and 12 should be formed in one or more optical areas OA1 and OA2.

The one or more optical electronic devices 11 and 12 are devices that require light reception, but are positioned behind (below, opposite to the viewing surface) the display panel 110 to receive the light transmitted through the display panel 110. The one or more optical electronic devices 11 and 12 are not exposed on the front surface (viewing surface) of the display panel 110. Therefore, when the user looks at the front surface of the display device 110, the optical electronic devices 11 and 12 are not visible to the user.

For example, the first optical electronic device 11 may be a camera, and the second optical electronic device 12 may be a detection sensor, such as a proximity sensor or an illuminance sensor. For example, the detection sensor may be an infrared sensor that detects infrared rays. Conversely, the first optical electronic device 11 may be a detection sensor, and the second optical electronic device 12 may be a camera.

Hereinafter, for convenience of description, it is assumed that the first optical electronic device 11 is a camera and the second electronic device 12 is an infrared (IR)-based detection sensor. The camera may be a camera lens or an image sensor.

If the first optical electronic device 11 is a camera, the camera may be a front camera that is positioned behind (below) the display panel 110 but captures forward of the display panel 110. Accordingly, the user may take a photograph through the camera invisible to the viewing surface while viewing the viewing surface of the display panel 110.

The normal area NA and one or more optical areas OA1 and OA2 included in the display area DA are areas that may display images, but the normal area NA is an area that does not require a light transmission structure to be formed, and the one or more optical areas OA1 and OA2 are areas that require a light transmission structure to be formed.

Accordingly, the one or more optical areas OA1 and OA2 should have a transmittance higher than or equal to a certain level, and the normal area NA may have no light transmittance or a lower transmittance less than the certain level.

For example, one or more optical areas OA1 and OA2 and the normal area NA may have different resolutions, subpixel placement structures, numbers of subpixels per unit area, electrode structures, line structures, electrode placement structures, or line placement structures.

For example, the number of subpixels per unit area in one or more optical areas OA1 and OA2 may be smaller than the number of subpixels per unit area in the normal area NA. In other words, the resolution of one or more optical areas OA1 and OA2 may be lower than the resolution of the normal area NA. Here, the number of subpixels per unit area may be meant to be equivalent to resolution, or pixel density, or pixel integration degree. For example, the unit for the number of subpixels per unit area may be pixels per inch (PPI), which means the number of pixels in one inch.

For example, the number of subpixels per unit area in the first optical area OA1 may be smaller than the number of subpixels per unit area in the normal area NA. The number of subpixels per unit area in the second optical area OA2 may be larger than or equal to the number of subpixels per unit area in the first optical area OA1 and be smaller than the number of subpixels per unit area in the normal area NA.

Meanwhile, as one method for increasing the transmittance of at least one of the first optical area OA1 and the second optical area OA2, a pixel density differential design scheme may be applied as described above. According to the pixel density differential design scheme, the display panel 110 may be designed so that the number of subpixels per unit area of at least one of the first optical area OA1 and the second optical area OA2 is smaller than the number of subpixels per unit area of the normal area NA.

However, in some cases, as another method for increasing the transmittance of at least one of the first optical area OA1 and the second optical area OA2, a pixel size differential design scheme may be applied. According to the pixel size differential design scheme, the display panel 110 may be designed so that the number of subpixels per unit area of at least one of the first optical area OA1 and the second optical area OA2 is identical or similar to the number of subpixels per unit area of the normal area NA, and the size of each subpixel (i.e., the size of the emission area) disposed in at least one of the first optical area OA1 and the second optical area OA2 is smaller than the size of each subpixel SP (i.e., the size of the emission area) disposed in the normal area NA.

Hereinafter, for convenience of description, it is assumed in the following description that, of the two schemes (pixel density differential design scheme and pixel size differential design scheme) for increasing the transmittance of at least one of the first optical area OA1 and the second optical area OA2, the pixel density differential design scheme is applied. Accordingly, that the number of subpixels per unit area is small, as described below, may be an expression corresponding to the subpixel size being small, and that the number of subpixels per unit area is large may be an expression corresponding to the subpixel size being large.

The first optical area OA1 may have various shapes, such as a circle, an ellipse, a quadrangle, a hexagon, or an octagon. The second optical area OA2 may have various shapes, such as a circle, an ellipse, a square, a hexagon, or an octagon. The first optical area OA1 and the second optical area OA2 may have the same shape or different shapes.

Referring to FIG. 1C, when the first optical area OA1 and the second optical area OA2 touch, the entire optical area including the first optical area OA1 and the second optical area OA2 may have various shapes, such as a circle, an ellipse, a square, a hexagon, or an octagon. Hereinafter, for convenience of description, each of the first optical area OA1 and the second optical area OA2 is exemplified as having a circular shape.

In the display device 100 according to examples of the disclosure, if the first optical electronic device 11 that is not exposed to the outside and is hidden in a lower portion of the display panel 100 is a camera, the display device 100 according to examples of the disclosure may be referred to as a display to which under display camera (UDC) technology has been applied.

Accordingly, the display device 100 according to examples of the disclosure does not require a notch or camera hole for camera exposure to be formed in the display panel 110, thereby preventing a reduction in the display area DA. Thus, as there is no need to form a notch or camera hole for exposure of the camera in the display panel 110, the size of the bezel area may be reduced, and design restrictions may be freed, thereby increasing the degree of freedom in design.

In the display device 100 according to examples of the disclosure, although one or more optical electronic devices 11 and 12 are positioned to be hidden behind the display panel 110, one or more optical electronic devices 11 and 12 should be able to normally perform predetermined functions by normally receiving light.

Further, in the display device 100 according to examples of the disclosure, although one or more optical electronic devices 11 and 12 are positioned to be hidden behind the display panel 110 and are positioned to overlap the display area DA, the one or more optical areas OA1 and OA2 overlapping the one or more optical electronic devices 11 and 12 in the display area DA should be capable of normal image display.

Since the above-mentioned first optical area OA1 is designed as a transmittable area, the image display characteristics in the first optical area OA1 may differ from the image display characteristics in the normal area NA.

Further, in designing the first optical area OA1 to enhance the image display characteristics, the transmittance of the first optical area OA1 may be degraded.

Accordingly, examples of the disclosure propose a structure of the first optical area OA1 capable of enhancing transmittance in the first optical area OA1 without causing an image quality deviation between the first optical area OA1 and the normal area NA.

Further, examples of the disclosure propose a structure of the second optical area OA2 capable of enhancing transmittance in the second optical area OA2 and image quality in the second optical area OA2 for the second optical area OA2, as well as for the first optical area OA1.

Further, in the display device 100 according to examples of the disclosure, the first optical area OA1 and the second optical area OA2 are similar in that they are light transmittable areas, but differ in use cases. Therefore, in the display device 100 according to examples of the disclosure, the structure of the first optical area OA1 and the structure of the second optical area OA2 may be designed to differ from each other.

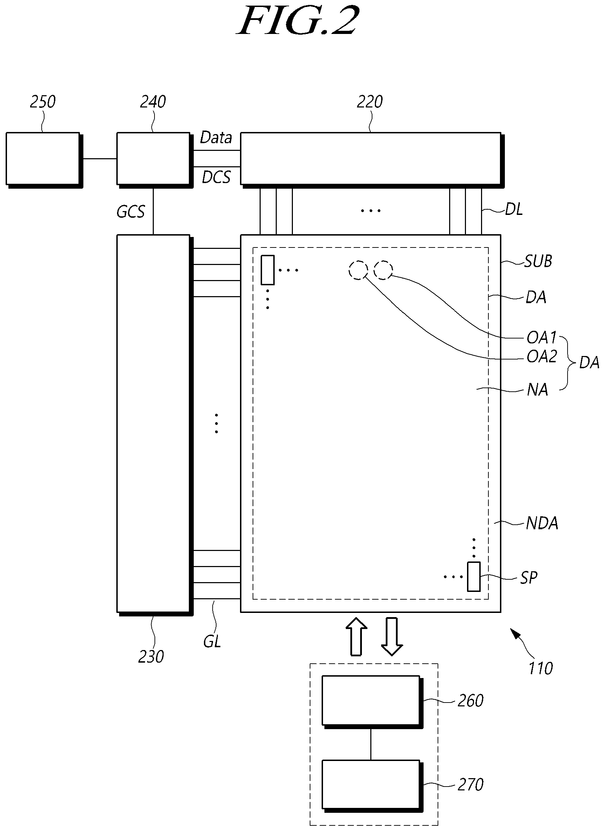

FIG. 2 is a view illustrating a system configuration of a display device 100 according to examples of the disclosure.

FIG. 2 is a view illustrating a system configuration of a display device 100 according to examples of the disclosure. Referring to FIG. 2, a display device 100 may include a display panel 110 and display driving circuits, as components for displaying images.

The display driving circuits are circuits for driving the display panel 110 and may include a data driving circuit 220, a gate driving circuit 230, and a display controller 240.

The display panel 110 may include a display area DA in which images are displayed and a non-display area NDA in which no image is displayed. The non-display area NDA may be an outer area of the display area DA and be referred to as a bezel area. The whole or part of the non-display area NDA may be an area visible from the front surface of the display device 100 or an area that is bent and not visible from the front surface of the display device 100.

The display panel 110 may include a substrate SUB and a plurality of subpixels SP disposed on the substrate SUB. The display panel 110 may further include various types of signal lines to drive the plurality of subpixels SP.

The display device 100 according to examples of the disclosure may be a liquid crystal display device or a self-emission display device in which the display panel 110 emits light by itself. When the display device 100 according to the examples of the disclosure is a self-emission display device, each of the plurality of subpixels SP may include a light emitting element. For example, the display device 100 according to examples of the disclosure may be an organic light emitting diode display in which the light emitting element is implemented as an organic light emitting diode (OLED). As another example, the display device 100 according to examples of the disclosure may be an inorganic light emitting display device in which the light emitting element is implemented as an inorganic material-based light emitting diode. As another example, the display device 100 according to examples of the disclosure may be a quantum dot display device in which the light emitting element is implemented as a quantum dot which is self-emission semiconductor crystal.

The structure of each of the plurality of subpixels SP may vary according to the type of the display device 100. For example, when the display device 100 is a self-emission display device in which the subpixels SP emit light by themselves, each subpixel SP may include a light emitting element that emits light by itself, one or more transistors, and one or more capacitors.

For example, various types of signal lines may include a plurality of data lines DL transferring data signals (also referred to as data voltages or image signals) and a plurality of gate lines GL transferring gate signals (also referred to as scan signals).

The plurality of data lines DL and the plurality of gate lines GL may cross each other. Each of the plurality of data lines DL may be disposed while extending in a first direction. Each of the plurality of gate lines GL may be disposed while extending in a second direction, which may be perpendicular to the first direction. Here, the first direction may be a column direction and the second direction may be a row direction. The first direction may be the row direction, and the second direction may be the column direction.

The data driving circuit 220 is a circuit for driving the plurality of data lines DL, and may output data signals to the plurality of data lines DL. The gate driving circuit 230 is a circuit for driving the plurality of gate lines GL, and may output gate signals to the plurality of gate lines GL.

The display controller 240 is a device for controlling the data driving circuit 220 and the gate driving circuit 230 and may control driving timings for the plurality of data lines DL and driving timings for the plurality of gate lines GL.

The display controller 240 may supply a data driving control signal DCS to the data driving circuit 220 to control the data driving circuit 220 and may supply a gate driving control signal GCS to the gate driving circuit 230 to control the gate driving circuit 230.

The display controller 240 may receive input image data from the host system 250 and supply image data Data to the data driving circuit 220 based on the input image data.

The data driving circuit 220 may receive digital image data Data from the display controller 240 and may convert the received image data Data into analog data signals and output the analog data signals to the plurality of data lines DL.

The gate driving circuit 230 may receive a first gate voltage corresponding to a turn-on level voltage and a second gate voltage corresponding to a turn-off level voltage, along with various gate driving control signals GCS, generate gate signals, and supply the generated gate signals to the plurality of gate lines GL.

For example, the data driving circuit 220 may be connected with the display panel 110 by a tape automated bonding (TAB) method or connected to a bonding pad of the display panel 110 by a chip on glass (COG) or chip on panel (COP) method or may be implemented by a chip on film (COF) method and connected with the display panel 110.

The gate driving circuit 230 may be connected with the display panel 110 by TAB method or connected to a bonding pad of the display panel 110 by a COG or COP method or may be connected with the display panel 110 according to a COF method. Alternatively, the gate driving circuit 230 may be formed in a gate in panel (GIP) type, in the non-display area NDAof the display panel 110. The gate driving circuit 230 may be disposed on the substrate or may be connected to the substrate. In other words, the gate driving circuit 230 that is of a GIP type may be disposed in the non-display area NDA of the substrate. The gate driving circuit 230 that is of a chip-on-glass (COG) type or chip-on-film (COF) type may be connected to the substrate.

Meanwhile, at least one of the data driving circuit 220 and the gate driving circuit 230 may be disposed in the display area DA of the display panel 110. For example, at least one of the data driving circuit 220 and the gate driving circuit 230 may be disposed not to overlap the subpixels SP or to overlap all or some of the subpixels SP.

The data driving circuit 220 may be connected to one side (e.g., an upper or lower side) of the display panel 110. Depending on the driving scheme or the panel design scheme, data driving circuits 220 may be connected with both the sides (e.g., both the upper and lower sides) of the display panel 110, or two or more of the four sides of the display panel 110.

The gate driving circuit 230 may be connected to one side (e.g., a left or right side) of the display panel 110. Depending on the driving scheme or the panel design scheme, gate driving circuits 230 may be connected with both the sides (e.g., both the left and right sides) of the display panel 110, or two or more of the four sides of the display panel 110.

The display controller 240 may be implemented as a separate component from the data driving circuit 220, or the display controller 140 and the data driving circuit 220 may be integrated into an integrated circuit (IC).

The display controller 240 may be a timing controller used in typical display technology, a control device that may perform other control functions as well as the functions of the timing controller, or a control device other than the timing controller, or may be a circuit in the control device. The display controller 240 may be implemented as various circuits or electronic components, such as an integrated circuit (IC), a field programmable gate array (FPGA), an application specific integrated circuit (ASIC), or a processor.

The display controller 240 may be mounted on a printed circuit board or a flexible printed circuit and may be electrically connected with the data driving circuit 220 and the gate driving circuit 230 through the printed circuit board or the flexible printed circuit.

The display controller 240 may transmit/receive signals to/from the data driving circuit 220 according to one or more predetermined interfaces. The interface may include, e.g., a low voltage differential signaling (LVDS) interface, an embedded clock point-point interface (EPI) interface, and a serial peripheral interface (SPI).

To provide a touch sensing function as well as an image display function, the display device 100 according to examples of the disclosure may include a touch sensor and a touch sensing circuit that senses the touch sensor to detect whether a touch occurs by a touch object, such as a finger or pen, or the position of the touch.

The touch sensing circuit may include a touch driving circuit 260 that drives and senses the touch sensor and generates and outputs touch sensing data and a touch controller 270 that may detect an occurrence of a touch or the position of the touch using touch sensing data.

The touch sensor may include a plurality of touch electrodes. The touch sensor may further include a plurality of touch lines for electrically connecting the plurality of touch electrodes and the touch driving circuit 260.

The touch sensor may be present in a touch panel form outside the display panel 110 or may be present inside the display panel 110. When the touch panel, in the form of a touch panel, exists outside the display panel 110, the touch panel is referred to as an external type. When the touch sensor is of the external type, the touch panel and the display panel 110 may be separately manufactured or may be combined during an assembly process. The external-type touch panel may include a touch panel substrate and a plurality of touch electrodes on the touch panel substrate.

When the touch sensor is present inside the display panel 110, the touch sensor may be formed on the substrate SUB, together with signal lines and electrodes related to display driving, during the manufacturing process of the display panel 110.

The touch driving circuit 260 may supply a touch driving signal to at least one of the plurality of touch electrodes and may sense at least one of the plurality of touch electrodes to generate touch sensing data.

The touch sensing circuit may perform touch sensing in a self-capacitance sensing scheme or a mutual-capacitance sensing scheme.

When the touch sensing circuit performs touch sensing in the self-capacitance sensing scheme, the touch sensing circuit may perform touch sensing based on capacitance between each touch electrode and the touch object (e.g., finger or pen). According to the self-capacitance sensing scheme, each of the plurality of touch electrodes may serve both as a driving touch electrode and as a sensing touch electrode. The touch driving circuit 260 may drive all or some of the plurality of touch electrodes and sense all or some of the plurality of touch electrodes.

When the touch sensing circuit performs touch sensing in the mutual-capacitance sensing scheme, the touch sensing circuit may perform touch sensing based on capacitance between the touch electrodes. According to the mutual-capacitance sensing scheme, the plurality of touch electrodes are divided into driving touch electrodes and sensing touch electrodes. The touch driving circuit 260 may drive the driving touch electrodes and sense the sensing touch electrodes.

The touch driving circuit 260 and the touch controller 270 included in the touch sensing circuit may be implemented as separate devices or as a single device. The touch driving circuit 260 and the data driving circuit 220 may be implemented as separate devices or as a single device.

The display device 100 may further include a power supply circuit for supplying various types of power to the display driver integrated circuit and/or the touch sensing circuit.

The display device 100 according to examples of the disclosure may be a mobile terminal, such as a smart phone or a tablet, or a monitor or television (TV) in various sizes but, without limited thereto, may be a display in various types and various sizes capable of displaying information or images.

As described above, the display area DA in the display panel 110 may include the normal area NA and one or more optical areas OA1 and OA2. The normal area NA and one or more optical areas OA1 and OA2 are areas capable of displaying an image. However, the normal area NA is an area where a light transmission structure is not required to be formed, and one or more optical areas OA1 and OA2 are areas in which a light transmission structure is to be formed.

As described above, the display area DA in the display panel 110 may include one or more optical areas OA1 and OA2 together with the normal area NA, but for convenience of description, it is assumed that the display area DA includes both the first optical area OA1 and the second optical area OA2 (FIGS. 1B and 1C).

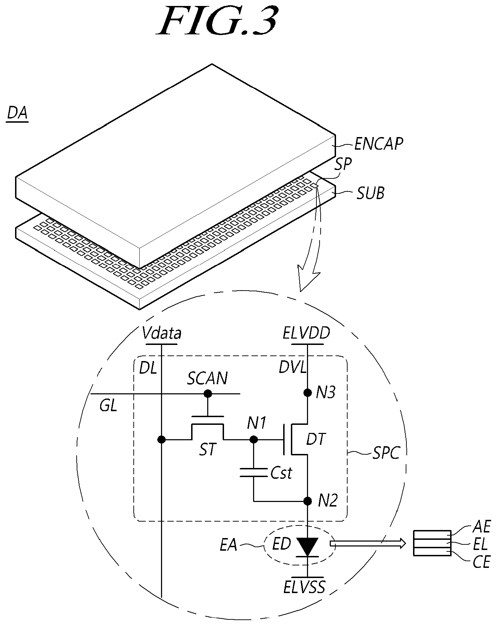

FIG. 3 is a view schematically illustrating a display panel 110 according to examples of the disclosure.

Referring to FIG. 3, a plurality of subpixels SP may be disposed in the display area DAof the display panel 110. The plurality of subpixels SP may be disposed in the normal area NA and the first optical area OA1 and the second optical area OA2 included in the display area DA.

Referring to FIG. 3, each of the plurality of subpixels SP may include a light emitting element ED and a subpixel circuit unit SPC configured to drive the light emitting element ED.

Referring to FIG. 3, the subpixel circuit unit SPC may include a driving transistor DT for driving the light emitting element ED, a scan transistor ST for transferring the data voltage Vdata to the first node N1 of the driving transistor DT, and a storage capacitor Cst for maintaining a constant voltage during one frame.

The driving transistor DT may include the first node N1 to which the data voltage may be applied, a second node N2 electrically connected with the light emitting element ED, and a third node N3 to which a driving voltage ELVDD is applied from a driving voltage line DVL. The first node N1 in the driving transistor DT may be a gate node, the second node N2 may be a source node or a drain node, and the third node N3 may be the drain node or the source node. For convenience of description, described below is an example in which the first node N1 in the driving transistor DT is a gate node, the second node N2 is a source node, and the third node N3 is a drain node.

The light emitting element ED may include an anode electrode AE, a light emitting layer EL, and a cathode electrode CE. The anode electrode AE may be a pixel electrode disposed in each subpixel SP and be electrically connected to the second node N2 of the driving transistor DT of each subpixel SP. The cathode electrode CE may be a common electrode commonly disposed in the plurality of subpixels SP, and a base voltage ELVSS may be applied thereto.

For example, the anode electrode AE may be a pixel electrode, and the cathode electrode CE may be a common electrode. Conversely, the anode electrode AE may be a common electrode, and the cathode electrode CE may be a pixel electrode. Hereinafter, for convenience of description, it is assumed that the anode electrode AE is a pixel electrode and the cathode electrode CE is a common electrode.

The light emitting element ED may have a predetermined emission area EA. The emission area EA of the light emitting element ED may be defined as an area where the anode electrode AE, the light emitting layer EL, and the cathode electrode CE overlap.

For example, the light emitting element ED may be an organic light emitting diode (OLED), an inorganic light emitting diode, or a quantum dot light emitting element. When the light emitting element ED is an organic light emitting diode, the light emitting layer EL of the light emitting element ED may include an organic light emitting layer EL including an organic material.

The scan transistor ST may be on/off controlled by a scan signal SCAN, which is a gate signal, applied via the gate line GL and be electrically connected between the first node N1 of the driving transistor DT and the data line DL.

The storage capacitor Cst may be electrically connected between the first node N1 and second node N2 of the driving transistor DT.

The subpixel circuit unit SPC may have a 2T (transistor)1C (capacitor) structure which includes two transistors DT and ST and one capacitor Cst as shown in FIG. 3 and, in some cases, each subpixel SP may further include one or more transistors or one or more capacitors.

The capacitor Cst may be an external capacitor intentionally designed to be outside the driving transistor DT, but not a parasite capacitor (e.g., Cgs or Cgd) which is an internal capacitor that may be present between the first node N1 and the second node N2 of the driving transistor DT. Each of the driving transistor DT and the scan transistor ST may be an n-type transistor or a p-type transistor.

Since the circuit elements (particularly, the light emitting element ED implemented as an organic light emitting diode (OLED) containing an organic material) in each subpixel SP are vulnerable to external moisture or oxygen, an encapsulation layer ENCAP may be disposed on the display panel 110 to prevent penetration of external moisture or oxygen into the circuit elements (particularly, the light emitting element ED). The encapsulation layer ENCAP may be disposed to cover the light emitting elements ED.

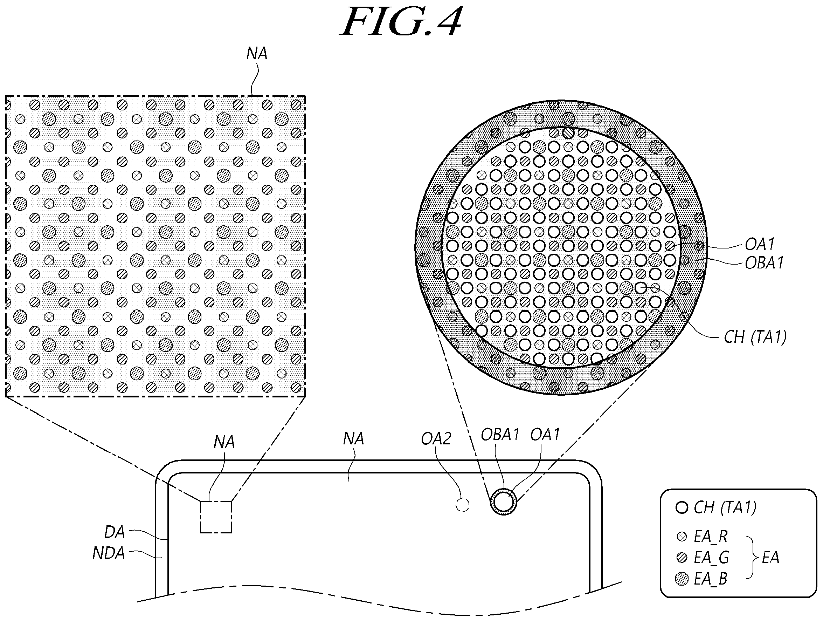

FIG. 4 schematically illustrates a normal area NA, a first optical bezel area OBA1, and a first optical area OA1 in a display panel according to examples of the disclosure.

Referring to FIG. 4, the display panel 110 according to examples of the disclosure may include a display area DA in which images are displayed and a non-display area NDA in which no image is displayed.

Referring to FIG. 4, the display area DA may include a first optical area OA1, a first optical bezel area OBA1, and a normal area NA.

Referring to FIG. 4, the first optical area OA1 is an area overlapping the first optical electronic device 11 and may be a transmittable area through which light required for operation of the first optical electronic device 11 may pass. Here, the light passing through the first optical area OA1 may include light of a single wavelength band or may include light of various wavelength bands. For example, the light passing through the first optical area OA1 may include at least one of visible light, infrared light, or ultraviolet light. For example, when the first optical electronic device 11 is a camera, the light transmitted through the first optical area OA1 and used by the first optical electronic device 11 may include visible light. As another example, when the first optical electronic device 11 is an infrared sensor, the light transmitted through the first optical area OA1 and used in the first optical electronic device 11 may include infrared light (also referred to as infrared light beam or ray).

Referring to FIG. 4, the first optical bezel area OBA1 may be an area positioned outside the first optical area OA1. The normal area NA may be an area positioned outside the first optical bezel area OBA1. The first optical bezel area OBA1 may be disposed between the first optical area OA1 and the normal area NA.

For example, the first optical bezel area OBA1 may be disposed only outside a part of the perimeter of the first optical area OA1 and may be disposed outside the entire perimeter of the first optical area OA1.

When the first optical bezel area OBA1 is disposed outside the entire perimeter of the first optical area OA1, the first optical bezel area OBA1 may have a ring shape surrounding the first optical area OA1.

For example, the first optical area OA1 may have various shapes, such as circular, elliptical, polygonal, or irregular shapes. The first optical bezel area OBA1 may have various ring shapes (e.g., a circular ring shape, an elliptical ring shape, a polygonal ring shape, or an irregular ring shape) surrounding the first optical area OA1 having various shapes.

Referring to FIG. 4, the display area DA may include a plurality of emission areas EA. Since the first optical area OA1, the first optical bezel area OBA1, and the normal area NA are areas included in the display area DA, each of the first optical area OA1, the first optical bezel area OBA1, and the normal area NA may include a plurality of emission areas EA.

For example, the plurality of light emitting areas EA may include a first color light emitting area emitting light of a first color, a second color light emitting area emitting light of a second color, and a third color light emitting area emitting light of a third color.

At least one of the first color emission area, the second color emission area, and the third color emission area may have a different area from the rest.

The first color, the second color, and the third color are different colors and may be various colors. For example, the first color, the second color, and the third color may include red, green, and blue.

Hereinafter, for convenience of description, a case in which the first color is red, the second color is green, and the third color is blue is exemplified. However, it is not limited thereto.

When the first color is red, the second color is green, and the third color is blue, among the area of the red emission area EA_R, the area of the green emission area EA_G, and the area of the blue emission area EA_B, the area of the blue emission area EA_B may be the largest.

The light emitting element ED disposed in the red emission area EA_R may include a light emitting layer EL emitting red light. The light emitting element ED disposed in the green emission area EA_G may include a light emitting layer EL emitting green light. The light emitting element ED disposed in the blue emission area EA_B may include a light emitting layer EL emitting blue light.

Among the light emitting layer EL emitting red light, the light emitting layer EL emitting green light, and the light emitting layer EL emitting blue light, an organic material included in the light emitting layer EL emitting blue light may be most easily deteriorated.

Since the area of the blue emission area EA_B is designed to be the largest, the density of the current supplied to the light emitting element ED disposed in the blue emission area EA_B may be the smallest. Accordingly, the degree of deterioration of the light emitting element ED disposed in the blue light emitting area EA_B may be similar to the degree of deterioration of the light emitting element ED disposed in the red light emitting area EA_R and the degree of deterioration of the light emitting element ED disposed in the green light emitting area EA_G.

Accordingly, the deterioration deviations between the light emitting element ED disposed in the red light emitting area EA_R, the light emitting element ED disposed in the green light emitting area EA_G, and the light emitting element ED disposed in the blue light emitting area EA_B may be removed or reduced, thereby improving image quality. Further, the deterioration deviations between the light emitting element ED disposed in the red light emitting area EA_R, the light emitting element ED disposed in the green light emitting area EA_G, and the light emitting element ED disposed in the blue light emitting area EA_B may be removed or reduced, thereby reducing the lifetime deviations between the light emitting element ED disposed in the red light emitting area EA_R, the light emitting element ED disposed in the green light emitting area EA_G, and the light emitting element ED disposed in the blue light emitting area EA_B.

Referring to FIG. 4, the first optical area OA1 is a transmittable area and must have high transmittance. To that end, the cathode electrode CE may include a plurality of cathode holes CH in the first optical area OA1. In other words, in the first optical area OA1, the cathode electrode CE may include a plurality of cathode holes CH.

Referring to FIG. 4, the cathode electrode CE does not include the cathode hole CH in the normal area NA. In other words, in the normal area NA, the cathode electrode CE does not include the cathode hole CH.

Further, the cathode electrode CE does not include the cathode hole CH in the first optical bezel area OBA1. In other words, in the first optical bezel area OBA1, the cathode electrode CE does not include the cathode hole CH.

In the first optical area OA1, the plurality of cathode holes CH formed in the cathode electrode CE may also be referred to as a plurality of first transmissive areas TA1 or a plurality of openings. Here, in FIG. 4, one cathode hole CH has a circular shape, but may have various shapes other than the circular shape, such as an elliptical shape, a polygonal shape, or an irregular shape.

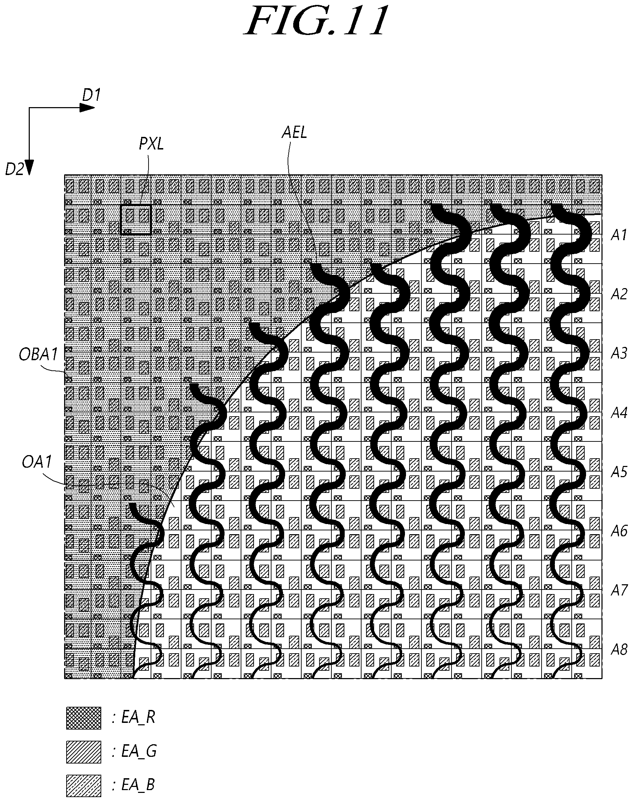

Referring to FIG. 4, the second optical area OA2 may be disposed adjacent to the first optical area OA1. The arrangement of the emission areas EA in the second optical area OA2 is described in more detail with reference to FIG. 11.

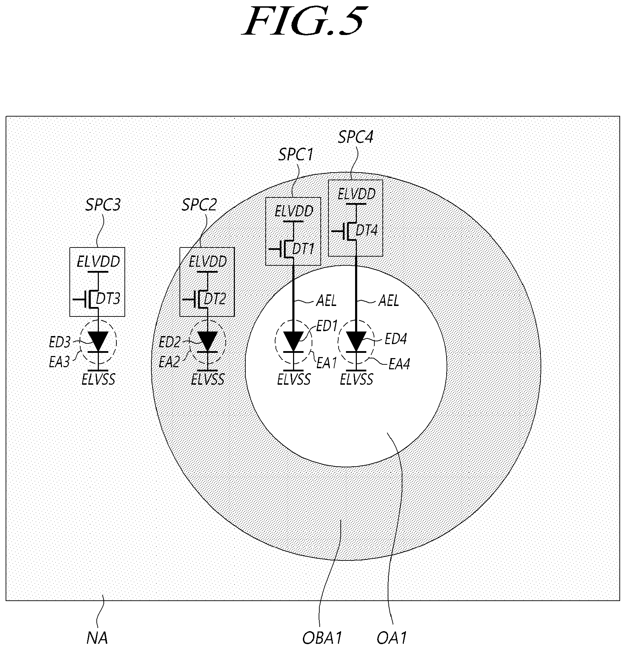

FIG. 5 illustrates, in the display panel 110 according to examples of the disclosure, light emitting devices ED1, ED2, ED3, and ED4 disposed in the general area NA, the first optical bezel area OBA1, and the first optical area OA1, and subpixel circuit units SPC1, SPC2, and SPC2 for driving the light emitting devices ED1, ED2, ED3, and ED4.

However, each of the subpixel circuit units SPC1, SPC2, SPC3, and SPC4 may include transistors DT and ST and a storage capacitor Cst as shown in FIG. 3. However, for convenience of description, each of the subpixel circuit units SPC1, SPC2, SPC3, and SPC4 is briefly expressed as a driving transistor DT1, DT2, DT3, and DT4, respectively.

Referring to FIG. 5, the normal area NA, the first optical area OA1, and the first optical bezel area OBA1 may have structural differences as well as positional differences.

As a structural difference, the subpixel circuit units SPC1, SPC2, SPC3, and SPC4 may be disposed in the first optical bezel area OBA1 and the normal area NA, but no subpixel circuit unit is disposed in the first optical area OA1. In other words, transistors DT1, DT2, DT3, and DT4 may be disposed in the first optical bezel area OBA1 and the normal area NA, but no transistors are disposed in the first optical area OA1.

The transistors and storage capacitors included in the subpixel circuit units SPC1, SPC2, SPC3, and SPC4 are components that may reduce transmittance. Accordingly, as the subpixel circuit units SPC1, SPC2, SPC3, and SPC are not disposed in the first optical area OA1, the transmittance of the first optical area OA1 may be further increased.

The subpixel circuit units SPC1, SPC2, SPC3, and SPC are disposed only in the normal area NA and the first optical bezel area OBA1, but the light emitting elements ED1, ED2, ED3, and ED4 may be disposed in all of the normal area NA, the first optical bezel area OBA1, and the first optical area OA1.

Referring to FIG. 5, the first light emitting element ED1 is disposed in the first optical area OA1, but the first subpixel circuit unit SPC1 for driving the first light emitting element ED1 is not disposed in the first optical area OA1.

Referring to FIG. 5, the first subpixel circuit unit SPC1 for driving the first light emitting element ED1 disposed in the first optical area OA1 is not disposed in the first optical area OA1 but may be disposed in the first optical bezel area OBA1.

Described below in greater detail are the normal area NA, the first optical area OA1, and the first optical bezel area OBA1.

Referring to FIG. 5, a plurality of emission areas EA included in the display panel 110 according to examples of the disclosure may include a first emission area EA1, a second emission area EA2, and a third emission area EA3. Here, the first emission area EA1 may be included in the first optical area OA1. The second emission area EA2 may be included in the first optical bezel area OBA1. The third emission area EA3 may be included in the normal area NA. Hereinafter, it is assumed that the first emission area EA1, the second emission area EA2, and the third emission area EA3 are emission areas of the same color.

Referring to FIG. 5, the display panel 110 according to examples of the disclosure may include a first light emitting element ED1 disposed in a first optical area OA1 and having a first emission area EA1, a second light emitting element ED2 disposed in a first optical bezel area OBA1 and having a second emission area EA2, and a third light emitting element ED3 disposed in a normal area NA and having a third emission area EA3.

Referring to FIG. 5, the display panel 110 according to examples of the disclosure may further include a first subpixel circuit unit SPC1 configured to drive the first light emitting element ED1, a second subpixel circuit unit SPC2 configured to drive the second light emitting element ED2, and a third subpixel circuit unit SPC3 configured to drive the third light emitting element ED3.

Referring to FIG. 5, the first subpixel circuit unit SPC1 may include a first driving transistor DT1. The second subpixel circuit unit SPC2 may include a second driving transistor DT2. The third subpixel circuit unit SPC3 may include a third driving transistor DT3.

Referring to FIG. 5, in the display panel 110 according to examples of the disclosure, the second subpixel circuit unit SPC2 may be disposed in the first optical bezel area OBA1 in which the corresponding second light emitting element ED2 is disposed, and the third subpixel circuit unit SPC3 may be disposed in the normal area NA in which the corresponding third light emitting element ED3 is disposed.

Referring to FIG. 5, in the display panel 110 according to examples of the disclosure, the first subpixel circuit unit SPC1 may not be disposed in the first optical area OA1 where the corresponding first light emitting device ED1 is disposed, but may be disposed in the first optical bezel area OBA1 positioned outside the first optical area OA1. Accordingly, the transmittance of the first optical area OA1 may be increased.

Referring to FIG. 5, the display panel 110 according to the examples of the disclosure may further include an anode extension line AEL that electrically connects the first subpixel circuit unit SPC1 disposed in the first optical bezel area OBA1 and the first light emitting element ED1 disposed in the first optical area OA1.

The anode extension line AEL may electrically extend the anode electrode AE of the first light emitting element ED1 to the second node N2 of the first driving transistor DT1 in the first subpixel circuit unit SPC1.

As described above, in the display panel 110 according to examples of the disclosure, the first subpixel circuitry portion SPC1 for driving the first light emitting element ED1 disposed in the first optical area OA1 may be disposed in the first optical bezel area OBA1, but not disposed in the first optical area OA1. Such a structure is also referred to as an anode extension structure.

When the display panel 110 according to examples of the disclosure has the anode extension structure, the whole or a portion of the anode extension line AEL may be disposed in the first optical area OA1, and the anode extension line AEL may include a transparent line. Accordingly, even when the anode extension line AEL connecting the first subpixel circuit unit SPC1 and the first light emitting element ED1 is disposed in the first optical area OA1, it is possible to prevent a drop in transmittance.

Referring to FIG. 5, the plurality of emission areas EA may further include a fourth emission area EA4 that emits light of the same color as the first emission area EA1 and is included in the first optical area OA1.

Referring to FIG. 5, the fourth emission area EA4 may be disposed adjacent to the first emission area EA1 in a row direction or column direction.

Referring to FIG. 5, the display panel 110 according to examples of the disclosure may further include a fourth light emitting element ED4 disposed in the first optical area OA1 and having a fourth emission area EA4, and a fourth subpixel circuit unit SPC4 configured to drive the fourth light emitting element ED4.

Referring to FIG. 5, the fourth subpixel circuit unit SPC4 may include a fourth driving transistor DT4. For convenience of description, the scan transistor ST and the storage capacitor Cst included in the fourth subpixel circuit unit SPC4 are omitted from FIG. 5.

Referring to FIG. 5, the fourth subpixel circuit unit SPC4 is a circuit for driving the fourth light emitting element ED4 disposed in the first optical area OA1, but may be disposed in the first optical bezel area OBA1.

Referring to FIG. 5, the display panel 110 according to examples of the disclosure may further include an anode extension line AEL that electrically connects the fourth subpixel circuit unit SPC4 and the fourth light emitting element ED4.

The whole or a portion of the anode extension line AEL may be disposed in the first optical area OA1, and the anode extension line AEL may include a transparent line.

As described above, the first subpixel circuit unit SPC1 disposed in the first optical bezel area OBA1 may drive one light emitting element ED1 disposed in the first optical area OA1. This circuit unit connection scheme is called a one-to-one (1:1) circuit unit connection scheme.

Accordingly, the number of subpixel circuit units SPC disposed in the first optical bezel area OBA1 may significantly increase. The structure of the first optical bezel area OBA1 may become complicated and the aperture ratio (or emission area) of the first optical bezel area OBA1 may decrease.

To increase the aperture ratio (or emission area) of the first optical bezel area OBA1 despite having the anode extension structure, the display device 100 according to examples of the disclosure may have a 1:N (where N is 2 or more) circuit unit connection scheme.

According to the 1:N circuit unit connection scheme, the first subpixel circuit unit SPC1 disposed in the first optical bezel area OBA1 may simultaneously drive two or more light emitting elements ED disposed in the first optical area OA1.

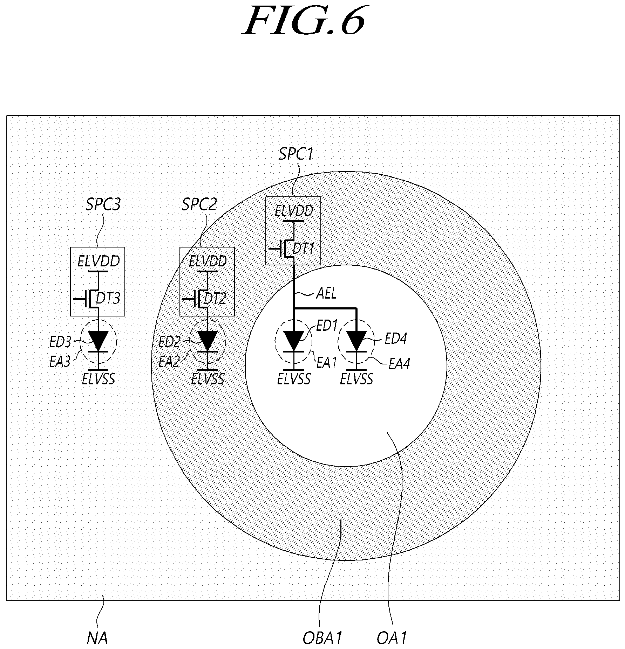

FIG. 6 illustrates an example in which, for convenience of description, a 1:2 circuit unit connection scheme is applied, that is, the first subpixel circuit unit SPC1 disposed in the first optical bezel area OBA1 simultaneously drives two or more light emitting elements ED1 and ED4 disposed in the first optical area OA1.

FIG. 6 illustrates the light emitting elements ED1, ED2, ED3, and ED4 disposed in the normal area NA, the first optical bezel area OBA1, and the first optical area OA1, and subpixel circuit units SPC1, SPC2, and SPC3 for driving the light emitting elements ED1, ED2, ED3, and ED4 in the display panel 110 according to examples of the disclosure.

Referring to FIG. 6, the fourth light emitting element ED4 disposed in the first optical area OA1 may be driven by the first subpixel circuit unit SPC1 for driving the first light emitting element ED1 disposed in the first optical area OA1. In other words, the first subpixel circuit unit SPC1 disposed in the first optical bezel area OBA1 may be configured to drive the first light emitting element ED1 and the fourth light emitting element ED4 disposed in the first optical area OA1 together.

Accordingly, although the display panel 110 has the anode extension structure, the number of subpixel circuit units SPC disposed in the first optical bezel area OBA1 may be reduced, thereby increasing the opening and emission area of the first optical bezel area OBA1.

In FIG. 6, the first light emitting element ED1 and the fourth light emitting element ED4 driven together by the first subpixel circuit unit SPC1 disposed in the first optical bezel area OBA1 are light emitting elements emitting light of the same color, and may be light emitting elements adjacent to each other in the row direction or column direction.

Referring to FIG. 6, the anode extension line AEL may connect the first subpixel circuit unit SPC1 disposed in the first optical bezel area OBA1 to the first light emitting element ED1 and the fourth light emitting element ED4 disposed in the first optical area OA1.

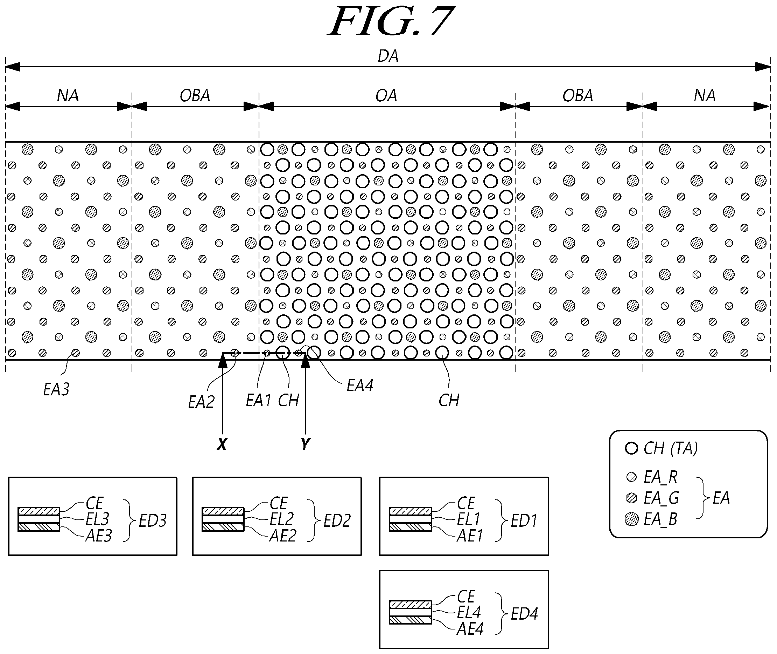

FIG. 7 is a plan view illustrating a normal area NA, an optical bezel area OBA, and an optical area OA in a display panel according to examples of the disclosure.

Referring to FIG. 7, in the display panel 110 according to examples of the disclosure, the plurality of emission areas EA disposed in each of the normal area NA, the optical bezel area OBA, and the optical area OA may include a red emission area EA_R, a green emission area EA_G, and a blue emission area EA_B.

Referring to FIG. 7, in the display panel 110 according to examples of the disclosure, the cathode electrode CE may be commonly disposed in the normal area NA, the optical bezel area OBA, and the optical area OA.

The cathode electrode CE may include a plurality of cathode holes CH, and the plurality of cathode holes CH of the cathode electrode CE may be disposed in the optical area OA.

The normal area NA and optical bezel area OBA may be an area where light is not transmissible, and the optical area OA may be an area where light is transmissible. Thus, the transmittance in the optical area OA may be higher than the transmittance in the optical bezel area OBA and normal area NA.

The entire optical area OA may be the area through which light may be transmitted, and the plurality of cathode holes CH within the optical area OA may be transmissive areas TA through which light may be better transmitted. In other words, the remaining area of the optical area OA except for the plurality of cathode holes CH may be an area through which light may be transmitted, and the transmittance of the plurality of cathode holes CH in the optical area OA may be higher than the transmittance of the remaining area of the optical area OA except for the plurality of cathode holes CH.

In contrast, the plurality of cathode holes CH in the optical area OA may be the transmissive area TA through which light may be transmitted, and the remaining area of the optical area OA except for the plurality of cathode holes CH may be an area where light is not transmitted.

Referring to FIG. 7, the arrangement of the emission areas EA in the optical area OA, the arrangement of the emission areas EA in the optical bezel area OBA, and the arrangement of the emission areas EA in the normal area NA may be identical to each other.

Referring to FIG. 7, the plurality of emission areas EAs may include a first emission area EA1 included in the optical area OA, a second emission area EA2 emitting light of the same color as the first emission area EA1 and included in an optical bezel area OBA, and a third emission area EA3 emitting light of the same color as the first emission area EA1 and included in the normal area NA.

Referring to FIG. 7, the plurality of emission areas EA may further include a fourth emission area EA4 that emits light of the same color as the first emission area EA1 and is included in the optical area OA.

Referring to Figure 7, the display panel 110 according to examples of the disclosure may include a first anode electrode AE1 disposed in the optical area OA, a second anode electrode AE2 disposed in the optical bezel area OBA, a third anode electrode AE3 disposed in the normal area NA, and a fourth anode electrode AE4 disposed in the optical area OA.

The display panel 110 according to examples of the disclosure may further include a cathode electrode CE disposed in common with the normal area NA, the optical bezel area OBA, and the optical area OA.

The display panel 110 according to examples of the disclosure may include a first light emitting layer EL1 disposed in the optical area OA, a second light emitting layer EL2 disposed in the optical bezel area OBA, a third light emitting layer EL3 disposed in the normal area NA, and a fourth light emitting layer EL4 disposed in the optical area OA.

The first to fourth light emitting layers EL4 may be light emitting layers that emit light of the same color. In this case, the first to fourth light emitting layers EL4 may be separately disposed or be integrated as one layer.

Referring to FIG. 7, the first light emitting element ED1 may be formed by the first anode electrode AE1, the first light emitting layer EL1, and the cathode electrode CE, the second light emitting element ED2 may be formed by the second anode electrode AE2, the second light emitting layer EL2, and the cathode electrode CE, the third light emitting element ED3 may be formed by the third anode electrode AE3, the third light emitting layer EL3, and the cathode electrode CE, and the fourth light emitting element ED4 may be formed by the fourth anode electrode AE4, the fourth light emitting layer EL4, and the cathode electrode CE.

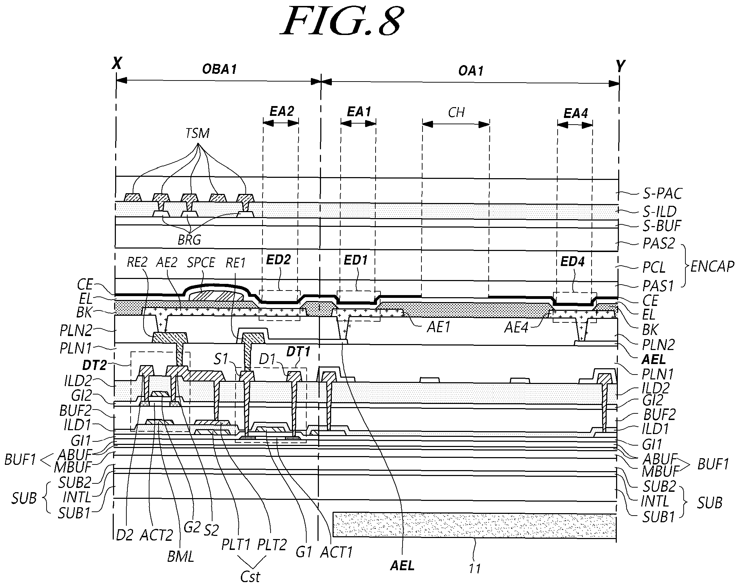

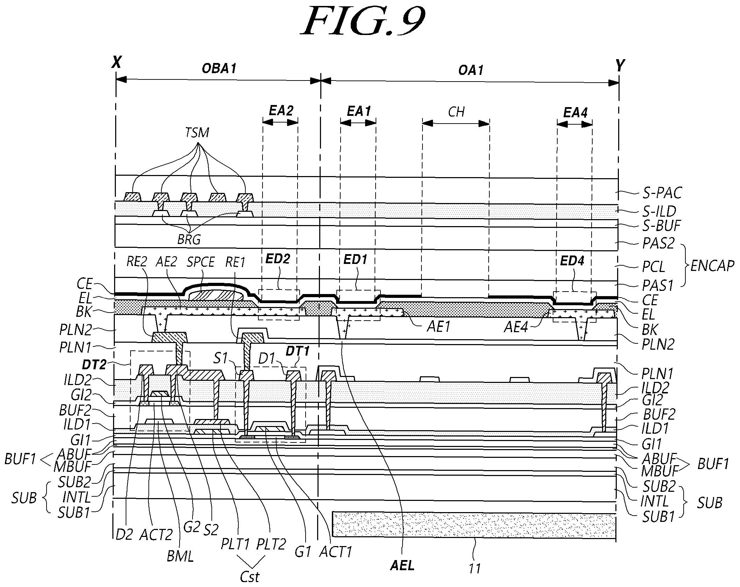

The cross-sectional structure taken along line X-Y of FIG. 7 is described below in greater detail with reference to FIGS. 8 and 9.

The portion of FIG. 7 taken along line X-Y of FIG. 7 includes a portion of the optical bezel area OBA and a portion of the optical area OAwith respect to the boundary between the optical bezel area OBA and the optical area OA.

The portion taken along line X-Y of FIG. 7 may include the first light emitting area EA1 and the fourth light emitting area EA4 included in the optical area OA, and the second light emitting area EA2 included in the optical bezel area OBA. The first emitting area EA1, fourth emitting area EA4, and second emitting area EA2 are examples of emission areas Eas that emit the same color of light.

FIG. 8 is a cross-sectional view illustrating a display panel 110, e.g., the optical bezel area OBA and the optical area OAof the display panel 110 according to examples of the disclosure. However, FIG. 8 is a cross-sectional view when the 1:1 circuit connection scheme is applied as in FIG. 5.

Referring to FIG. 8, when viewed in a vertical structure, the display panel 110 may include a transistor forming part, a light emitting element forming part, and an encapsulation part.

The transistor forming part may include a substrate SUB, a first buffer layer BUF1 on the substrate SUB, and various transistors DT1 and DT2, storage capacitor Cst, and various electrodes or signal lines formed on the first buffer layer BUF.

The substrate SUB may include a first substrate SUB1 and a second substrate SUB2. An intermediate film INTL may be present between the first and second substrates SUB1 and SUB2. For example, the intermediate film INTL may be an inorganic film and may block moisture penetration.

A lower shield metal BSM may be disposed on the substrate SUB. The lower shield metal BSM may be positioned under the first active layer ACT1 of the first driving transistor DT1.

The first buffer layer BUF1 may be a single film or multi-film structure. When the first buffer layer BUF1 is formed in a multi-film structure, the first buffer layer BUF1 may include a multi-buffer layer MBUF and an active buffer layer ABUF.

Various transistors DT1 and DT2, storage capacitor Cst, and various electrodes or signal lines may be formed on the first buffer layer BUF1.

For example, the transistors DT1 and DT2 formed on the first buffer layer BUF1 are formed of the same material and on the same layer. Alternatively, as illustrated in FIG. 8, among the transistors DT1 and DT2, the first driving transistor DT1 and the second driving transistor DT2 may be formed of different materials and may be positioned on different layers.

Referring to FIG. 8, the first driving transistor DT1 may be a driving transistor DT for driving the first light emitting element ED1 included in the optical area OA, and the second driving transistor DT2 may be a driving transistor DT for driving the second light emitting element ED2 included in the optical bezel region OBA.

In other words, the first driving transistor DT1 may be a driving transistor included in the first pixel circuit SPC1 for driving the first light emitting element ED1 included in the optical area OA, and the second driving transistor DT2 may be a driving transistor included in the second pixel circuit SPC2 for driving the second light emitting element ED2 included in the optical bezel area OBA.

The formation of the first driving transistor DT1 and the second driving transistor DT2 is described below.

The first driving transistor DT1 may include a first active layer ACT1, a first gate electrode G1, a first source electrode S1, and a first drain electrode D1.

The second driving transistor DT2 may include a second active layer ACT2, a second gate electrode G2, a second source electrode S2, and a second drain electrode D2.

The second active layer ACT2 of the second driving transistor DT2 may be positioned higher than the first active layer ACT1 of the first driving transistor DT1.

A first buffer layer BUF1 may be disposed under the first active layer ACT1 of the first driving transistor DT1, and a second buffer layer BUF2 may be disposed under the second active layer ACT2 of the second driving transistor DT2.

In other words, the first active layer ACT1 of the first driving transistor DT1 may be positioned on the first buffer layer BUF1, and the second active layer ACT2 of the second driving transistor DT2 may be positioned on the second buffer layer BUF2. Here, the second buffer layer BUF2 may be positioned higher than the first buffer layer BUF1.

The first active layer ACT1 of the first driving transistor DT1 may be disposed on the first buffer layer BUF1, and a first gate insulation film GI1 may be formed on the first active layer ACT1 of the first driving transistor DT1. The first gate electrode G1 of the first driving transistor DT1 may be disposed on the first gate insulation film GI1, and a first inter-layer insulation film ILD1 may be disposed on the first gate electrode G1 of the first driving transistor DT1.

Here, the first active layer ACT1 of the first driving transistor DT1 may include a first channel area overlapping the first gate electrode G1, a first source connection area positioned on one side of the first channel area, and a channel area, and a first drain connection area positioned on the other side of the channel area.

A second buffer layer BUF2 may be disposed on the first inter-layer insulation film ILD1.

The second active layer ACT2 of the second driving transistor DT2 may be disposed on the second buffer layer BUF2, and a second gate insulation film GI2 may be disposed on the second active layer ACT2. The second gate electrode G2 of the second driving transistor DT2 may be disposed on the second gate insulation film GI2, and a second inter-layer insulation film ILD2 may be disposed on the second gate electrode G2.

Here, the second active layer ACT2 of the second driving transistor DT2 may include a second channel area overlapping the second gate electrode G2, a second source connection area positioned on one side of the second channel area, and a second drain connection area positioned on the other side of the channel area.

The first source electrode S1 and the first drain electrode D1 of the first driving transistor DT1 may be disposed on the second inter-layer insulation film ILD2. The second source electrode S2 and the second drain electrode D2 of the second driving transistor DT2 may be disposed on the second inter-layer insulation film ILD2.

The first source electrode S1 and the first drain electrode D1 of the first driving transistor DT1 may be connected with the first source connection area and the first drain connection area, respectively, of the first active layer ACT1 through the through holes of the second inter-layer insulation film ILD2, the second gate insulation film GI2, the second buffer layer BUF2, the first inter-layer insulation film ILD1, and the first gate insulation film GI1.

The second source electrode S2 and the second drain electrode D21 of the second driving transistor DT2 may be connected with the second source connection area and the second drain connection area, respectively, of the second active layer ACT2 through the through holes in the second inter-layer insulation film ILD2 and the second gate insulation film GI2.

In FIG. 8, only the first driving transistor DT1 and the storage capacitor Cst included in the second pixel circuit SPC2 are shown, with other transistors omitted. In FIG. 8, only the first driving transistor DT1 included in the first pixel circuit SPC1 is shown, with other transistors and storage capacitor omitted.

Referring to FIG. 8, the storage capacitor Cst included in the second pixel circuit SPC2 may include a first capacitor electrode PLT1 and a second capacitor electrode PLT2.

The first capacitor electrode PLT1 may be electrically connected to the second gate electrode G2 of the second driving transistor DT2, and the second capacitor electrode PLT2 may be electrically connected to the second source electrode S2 of the second driving transistor DT2.

Meanwhile, referring to FIG. 8, a lower metal BML may be disposed under the second active layer ACT2 of the second driving transistor DT2. The lower metal BML may overlap the whole or part of the second active layer ACT2.

For example, the lower metal BML may be electrically connected to the second gate electrode G2. As another example, the lower metal BML may serve as a light shield to block the light introduced from thereunder. In this case, the lower metal BML may be electrically connected to the second source electrode S2.

The first driving transistor DT1 is a transistor for driving the first light emitting element ED1 disposed in the optical area OA, but may be disposed in the optical bezel area OBA.

The second driving transistor DT2 is a transistor for driving the second light emitting element ED2 disposed in the optical bezel area OBA, and may be disposed in the optical bezel area OBA.

Referring to FIG. 8, a first planarization layer PLN1 may be disposed on the first driving transistor DT1 and the second driving transistor DT2. In other words, the first planarization layer PLN1 may be disposed on the first source electrode S1 and the first drain electrode D2 of the first driving transistor DT1 and the second source electrode S2 and the second drain electrode D2 of the second driving transistor DT2.

Referring to FIG. 8, a first relay electrode RE1 and a second relay electrode RE2 may be disposed on the first planarization layer PLN1.

Here, the first relay electrode RE1 may be an electrode that relays an electrical connection between the first source electrode S1 of the first driving transistor DT1 and the first anode electrode AE1 of the first light emitting element ED1. The second relay electrode RE2 may be an electrode that relays an electrical connection between the second source electrode S2 of the second driving transistor DT2 and the second anode electrode AE2 of the second light emitting element ED2.

The first relay electrode RE1 may be electrically connected to the first source electrode S1 of the first driving transistor DT1 through a hole in the first planarization layer PLN1. The second relay electrode RE2 may be electrically connected to the second source electrode S2 of the second driving transistor DT2 through another hole in the first planarization layer PLN1.

Referring to FIG. 8, the first relay electrode RE1 and the second relay electrode RE2 may be disposed in the optical bezel area OBA.

Meanwhile, referring to FIG. 8, the anode extension line AEL may be connected to the first relay electrode RE1 and may extend from the optical bezel area OBA to the optical area OA.

Referring to FIG. 8, the anode extension line AEL is a metal layer formed on the first relay electrode RE1 and may be formed of a transparent material.

Referring to FIG. 8, a second planarization layer PLN2 may be disposed covering the first relay electrode RE1, the second relay electrode RE2, and the anode extension line AEL.

Referring to FIG. 8, a light emitting element forming part may be positioned on the second planarization layer PNL2.

Referring to FIG. 8, the light emitting element forming part may include a first light emitting element ED1, a second light emitting element ED2, and a fourth light emitting element ED4 formed on the second planarization layer PNL2.

Referring to FIG. 8, the first light emitting element ED1 and the fourth light emitting element ED4 may be disposed in the optical area OA, and the second light emitting element ED2 may be disposed in the optical bezel area OBA.

In the example of FIG. 8, the first light emitting element ED1, the second light emitting element ED2, and the fourth light emitting element ED4 are light emitting elements emitting light of the same color. Hereinafter, it is assumed that the respective light emitting layers EL of the first light emitting element ED1, the second light emitting element ED2, and fourth light emitting element ED4 are formed in common, although they may be formed separately.

Referring to FIG. 8, the first light emitting element ED1 may be formed in an area where the first anode electrode AE1, the light emitting layer EL, and the cathode electrode CE overlap. The second light emitting element ED2 may be formed in an area where the second anode electrode AE2, the light emitting layer EL, and the cathode electrode CE overlap. The fourth light emitting element ED4 may be formed in an area where the fourth anode electrode AE4, the light emitting layer EL, and the cathode electrode CE overlap.

Referring to FIG. 8, the first anode electrode AE1, the second anode electrode AE2, and the fourth anode electrode AE4 may be disposed on the second planarization layer PLN2.

The second anode electrode AE2 may be connected to the second relay electrode RE2 through a hole in the second planarization layer PLN2.

The first anode electrode AE1 may be connected to the anode extension line AEL extending from the optical bezel area OBA to the optical area OA through another hole in the second planarization layer PLN2.

The fourth anode electrode AE4 may be connected to another anode extension line AEL extending from the optical bezel area OBA to the optical area OA through another hole in the second planarization layer PLN2.

Referring to FIG. 8, a bank BK may be disposed on the first anode electrode AE1, the second anode electrode AE2, and the fourth anode electrode AE4.

The bank BK may include a plurality of bank holes. The respective portions of the first anode electrode AE1, the second anode electrode AE2, and the fourth anode electrode AE4 may be exposed through the plurality of bank holes. In other words, the plurality of bank holes formed in the bank BK may overlap the respective portions of the first anode electrode AE1, the second anode electrode AE2, and the fourth anode electrode AE4.

Referring to FIG. 8, a light emitting layer EL may be disposed on the bank BK. The light emitting layer EL may contact a portion of the first anode electrode AE1, a portion of the second anode electrode AE2, and a portion of the fourth anode electrode AE4 through a plurality of bank holes.

Referring to FIG. 8, at least one space SPC may be present between the light emitting layer EL and the bank BK.

Referring to FIG. 8, the cathode electrode CE may be disposed on the light emitting layer EL. The cathode electrode CE may include a plurality of cathode holes CH. A plurality of cathode holes CH formed in the cathode electrode CE may be disposed in the optical area OA.

One cathode hole CH illustrated in FIG. 8 is a cathode hole positioned between the first emission area EA1 and the fourth emission area EA4.

Referring to FIG. 8, an encapsulation part may be positioned on the cathode electrode CE. The encapsulation part may include an encapsulation layer ENCAP formed on the cathode electrode CE.

Referring to FIG. 8, the encapsulation layer ENCAP may be a layer that prevents penetration of moisture or oxygen into the light emitting elements ED1, ED2, and ED4 disposed under the encapsulation layer ENCAP. In particular, the encapsulation layer ENCAP may prevent penetration of moisture or oxygen into the light emitting layer EL, which may include an organic film. Here, the encapsulation layer ENCAP may be composed of a single film or a multi-film structure.

The encapsulation layer ENCAP may include a first encapsulation layer PAS1, a second encapsulation layer PCL, and a third encapsulation layer PAS2. The first encapsulation layer PAS1 and the third encapsulation layer PAS2 may be inorganic films, and the second encapsulation layer PCL may be an organic layer.

As the second encapsulation layer PCL is formed of an organic film, the second encapsulation layer PCL may serve as a planarization layer.

Meanwhile, the display panel 110 according to examples of the disclosure may include a touch sensor. In this case, the display panel 110 according to examples of the disclosure may include a touch sensor portion formed on the encapsulation layer ENCAP.

Referring to FIG. 8, the touch sensor portion may include touch sensor metals TSM and bridge metals BRG and may further include insulation film components, such as a sensor buffer layer S-BUF, a sensor inter-layer insulation film S-ILD, and a sensor protection layer S-PAC.

The sensor buffer layer S-BUF may be disposed on the encapsulation layer ENCAP. The bridge metals BRG may be disposed on the sensor buffer layer S-BUF. The sensor inter-layer insulation film S-ILD may be disposed on the bridge metals BRG.

The touch sensor metals TSM may be disposed on the sensor inter-layer insulation film S-ILD. Some of the touch sensor metals TSM may be connected to the corresponding bridge metal BRG through a hole in the sensor inter-layer insulation film S-ILD.

Referring to FIG. 8, the touch sensor metals TSM and the bridge metals BRG may be disposed in the optical bezel area OBA. The touch sensor metals TSM and the bridge metals BRG may be disposed not to overlap the second emission area EA2 of the optical bezel area OBA.

The plurality of touch sensor metals TSM may configure one touch electrode (or one touch electrode line) and may be disposed in a mesh form and electrically connected. Some of the touch sensor metals TSM and some others of the touch sensor metals TSM may be electrically connected through a bridge metal BRG, configuring one touch electrode (or one touch electrode line).

The sensor protection layer S-PAC may be disposed while covering the touch sensor metals TSM and the bridge metals BRG.

Meanwhile, when the display panel 110 is of a type that incorporates touch sensors, at least a portion of the touch sensor metal TSM positioned on the encapsulation layer ENCAP in the display area DA may extend and be disposed along the outer inclined surface of the encapsulation layer ENCAP to electrically connect to a pad positioned further outside the outer inclined surface of the encapsulation layer ENCAP. Here, the pad may be disposed in the non-display area NDA and may be a metal pattern to which the touch driving circuit 260 is electrically connected.

The display panel 110 according to examples of the disclosure may further include a bank BK positioned on the first anode electrode AE1 and having a bank hole exposing a portion of the first anode electrode AE1 and a light emitting layer EL positioned on the bank BK and contacting a portion of the first anode electrode AE1 exposed through the bank hole.

The bank hole formed in the bank BK may not overlap the plurality of cathode holes CH. In other words, at the point where the cathode hole CH is positioned, the bank BK is not depressed or bored through. Therefore, at the point where the cathode hole CH is positioned, the second planarization layer PLN2 and the first planarization layer PLN1 positioned under the bank BK are not depressed or bored through either.

An upper surface of the bank BK positioned under the plurality of cathode holes CH may be in a flat state without being damaged, meaning that the insulation layer, metal pattern (electrodes or lines), or light emitting layer EL positioned under the cathode electrode CE is not damaged by the process of forming the plurality of cathode holes CH in the cathode electrode CE.

The process of forming the plurality of cathode holes CH in the cathode electrode CE is briefly described below. A specific mask pattern (anti-deposition pattern (not shown)) is deposited in positions where a plurality of cathode holes CH are to be formed, and a cathode electrode material is deposited thereon. Accordingly, the cathode electrode material may be deposited only in an area without the specific mask pattern, so that the cathode electrode CE having a plurality of cathode holes CH may be formed. For example, the specific mask pattern may include an organic material. The cathode electrode material may include a magnesium-silver (Mg-Ag) alloy.

Meanwhile, after the cathode electrode CE having the plurality of cathode holes CH is formed, the display panel 110 may be in a state in which the specific mask pattern is completely removed or in a state in which the whole or part of the specific mask pattern remains.

The display panel 110 according to examples of the disclosure may include a first driving transistor DT1 disposed in the optical bezel area OBA to drive the first light emitting element ED1 disposed in the optical area OA and a second driving transistor DT2 disposed in the optical bezel area OBA to drive the second light emitting element ED2 disposed in the optical bezel area OBA.

The display panel 110 according to examples of the disclosure may further include a first planarization layer PLN1 disposed on the first driving transistor DT1 and the second driving transistor DT2, a first relay electrode RE1 positioned on the first planarization layer PLN1 and electrically connected to the first source electrode S1 of the first driving transistor DT1 through a hole of the first planarization layer PLN1, a second relay electrode RE2 positioned on the first planarization layer PLN1 and electrically connected to the second source electrode S2 of the second driving transistor DT2 through another hole of the first planarization layer PLN1, and a second planarization layer PLN2 disposed on the first relay electrode RE1 and the second relay electrode RE2.

The display panel 110 according to examples of the disclosure may further include an anode extension line AEL connecting the first relay electrode RE1 and the first anode electrode AE1 and positioned on the first planarization layer PLN1.

The second anode electrode AE2 may be electrically connected to the second relay electrode RE2 through a hole in the second planarization layer PLN2, and the first anode electrode AE1 may be electrically connected to the anode extension line AEL through another hole in the second planarization layer PLN2.

The whole or a portion of the anode extension line AEL may be disposed in the optical area OA, and the anode extension line AEL may include a transparent material.

The first pixel circuit SPC1 may include a first driving transistor DT1 for driving the first light emitting element ED1. The second pixel circuit SPC2 may include a second driving transistor DT2 for driving the second light emitting element ED2.

The first active layer ACT1 of the first driving transistor DT1 and the second active layer ACT2 of the second driving transistor DT2 may be different from each other.

The display panel 110 according to examples of the disclosure may further include a substrate SUB, a first buffer layer BUF1 disposed between the substrate SUB and the first driving transistor DT1, and a second buffer layer BUF2 disposed between the first driving transistor DT1 and the second driving transistor DT2.

The first active layer ACT1 of the first driving transistor DT1 and the second active layer ACT2 of the second driving transistor DT2 may comprise different semiconductor materials.

For example, the second active layer ACT2 of the second driving transistor DT2 may include an oxide semiconductor material. For example, the oxide semiconductor material may include indium gallium zinc oxide (IGZO), indium gallium zinc tin oxide (IGZTO), zinc oxide (ZnO), cadmium oxide (CdO), indium oxide (InO), zinc tin oxide (ZTO), and zinc indium tin oxide (ZITO).

For example, the first active layer ACT1 of the first driving transistor DT1 and the second active layer ACT2 of the second driving transistor DT2 may comprise different semiconductor materials.

For example, the first active layer ACT1 of the first driving transistor DT1 may include a silicon-based semiconductor material. For example, the silicon-based semiconductor material may include low-temperature polycrystalline silicon (LTPS) or the like.

The display panel 110 according to examples of the disclosure may further include an encapsulation layer ENCAP on a first light emitting element ED1, a second light emitting element ED2, and a third light emitting element ED3, and a touch sensor metal TSM on the encapsulation layer ENCAP.

The touch sensor metal TSM may be disposed in the normal area NA and the optical bezel area OBA. In the optical area OA, the touch sensor metal TSM may not be disposed or may be disposed at a lower density than in the normal area NA and the optical bezel area OBA.

Referring to FIG. 8, the optical area OA may overlap the optical electronic device. The optical bezel area OBA may not overlap the optical electronic device. In some cases, a portion of the optical bezel area OBA may overlap the optical electronic device.

The optical electronic device overlapping the optical area OA may be the first optical electronic device 11 and/or the second optical electronic device 12. For example, the optical electronic device may include a camera, an infrared sensor, or an ultraviolet sensor. For example, an optical electronic device may be a device that receives visible light and performs a predetermined operation, or may be a device that receives other rays (e.g., infrared rays, ultraviolet rays) than visible light and performs a predetermined operation.

Referring to FIG. 8, the cross-sectional structure of the normal area NA may be the same as that of the optical bezel area OBA. However, the first pixel circuit SPC1 disposed in the optical bezel area OBA to drive the first light emitting element ED1 disposed in the optical area OA is not disposed in the normal area NA.

FIG. 9 is a cross-sectional view illustrating a display panel 110, e.g., the optical bezel area OBA and the optical area OAof the display panel 110 according to examples of the disclosure. However, FIG. 9 is a cross-sectional view when the 1:2 circuit connection scheme is applied as in FIG. 6.

The cross-sectional view of FIG. 9 is basically the same as the cross-sectional view of FIG. 8. The only difference is that the cross-sectional view of FIG. 8 adopts the 1:1 circuit unit connection scheme shown in FIG. 5 while the cross-sectional view of FIG. 9 adopts the 1:2 circuit unit connection scheme shown in FIG. 6. Thus, the following description of the cross-sectional structure of FIG. 9 focuses primarily on differences from the cross-sectional structure of FIG. 8.

Referring to FIG. 9, the first light emitting element ED1 and the fourth light emitting element ED4 disposed in the optical area OA may be simultaneously driven by the first driving transistor DT1 disposed in the optical bezel area OBA.

Therefore, as illustrated in FIG. 9, the anode extension line AEL may be further electrically connected to the fourth anode electrode AE4 different from the first anode electrode AE1. In other words, the anode extension line AEL may be electrically connected to both the first anode electrode AE1 of the first light emitting element ED1 and the fourth anode electrode AE4 of the fourth light emitting element ED4.

Referring to FIG. 9, the anode extension line AEL may overlap the cathode hole CH positioned between the first light emitting element ED1 and the fourth light emitting element ED4 among the plurality of cathode holes CH.

Referring to FIG. 9, the first emission area EA1 by the first light emitting element ED1 and the fourth emission area EA4 by the fourth light emitting element ED4 may be emission areas emitting light of the same color.

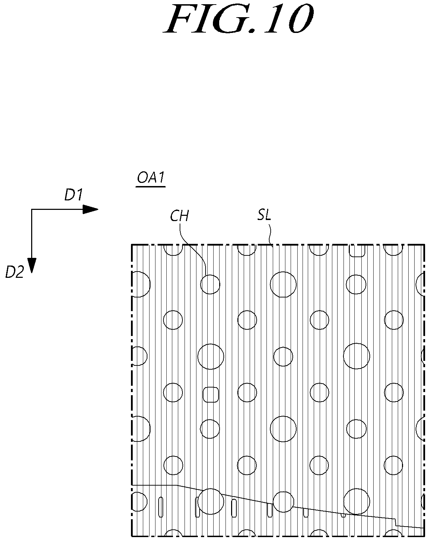

FIG. 10 is a plan view illustrating a first optical area OA1 of a display device according to a comparative example of the disclosure.

Referring to FIG. 10, the display device may include a plurality of cathode holes CH in the first optical area OA1.

The display device may include a plurality of signal lines SL extending and positioned in the second direction D2. The plurality of signal lines SL may be disposed in plurality in the first direction D1.

As the plurality of signal lines SL, which may be arranged in the first direction D1 and extend in the second direction D2, are positioned in the first optical area OA1, the plurality of signal lines SL are arranged on the optical electronic device, e.g., a camera, positioned under the first optical area OA1. When the optical electronic device is a camera, the camera receives light passing between the plurality of signal lines SL and photographs the screen, so that a flare in a specific direction may be photographed in the camera. For example, when a plurality of signal lines SL extending in the second direction D2 are disposed in the first direction D1, flare may occur in the first direction D1.

The inventors of the disclosure have invented a display device having a curved anode extension line to address the issue.

FIG. 11 is a plan view illustrating a portion of a display area of a display device according to examples of the disclosure.

Referring to FIGS. 4, 5, 6, 8, 9, and 11, a display device according to examples of the disclosure may include a display area DA, a cathode electrode CE, a first light emitting element ED1, a first sub-pixel circuit unit SPC1, and an anode extension line AEL.

More specifically, referring to FIG. 4, the display area DA may include a first optical area OA1 and a first optical bezel area OBA1 positioned outside the first optical area OA1. More specifically, referring to FIGS. 8 and 9, the cathode electrode CE may include a plurality of cathode holes CH in the first optical area OA1. The first light emitting element ED1 may be positioned in the first optical area OA1 and may include a first anode electrode AE1. More specifically, referring to FIGS. 5 and 6, the first subpixel circuit unit SPC1 may be positioned in the first optical bezel area OBA1. Referring to FIGS. 5, 6, 8, and 9, the anode extension line AEL may electrically connect the first subpixel circuit unit SPC1 and the first anode electrode AE1. Referring to FIG. 11, the anode extension line AEL may have a curved shape.

Referring to FIG. 11, when the anode extension line AEL extends in the second direction D2 and the shape of the anode extension line AEL is curved, although the plurality of anode extension lines AEL are disposed in the first direction D1, it is possible to suppress flare when the optical electronic device positioned to overlap the first optical area OA1 is used. As shown in Fig. 11, the number of anode extension lines per unit area decreases from an edge of the first optical area to a centre of the first optical area. Moreover, the plurality of anode extension lines are divided into a plurality of groups, and the thickness of each of the plurality of groups decreases from an edge of the first optical area to a centre of the first optical area.

The display device may include a plurality of anode extension lines AEL. Since the anode extension line AEL denotes a line for electrically connecting the anode electrodes of the plurality of light emitting elements positioned in the first optical area OA1 and the plurality of subpixel circuit units positioned in the first optical bezel area OBA1, the display device may include a plurality of anode extension lines AEL.

The number of anode extension lines AEL may decrease toward the center of the first optical area OA1. For example, in row A1 of the first optical area OA1, a large number of anode extension lines AEL may be positioned to overlap one pixel PXL and, in row A8 which is closer to the center of the first optical area OA1, a smaller number of anode extension lines AEL may be positioned to overlap one pixel PXL. This is because the numbers of light emitting elements and subpixel circuit units to be electrically connected by the anode extension line AEL decrease from rowA1 to row A8.

The anode extension line AEL may be positioned not to overlap the cathode hole. Referring to FIG. 11, a plurality of pixels PXL may be disposed in the first optical area OA1 and the first optical bezel area OBA1. Each of the pixels PXL may include, e.g., a red emission area EA_R, a green emission area EA_G, and a blue emission area EA_B. Further, as described above with reference to FIGS. 4 and 7, cathode holes CH may be disposed in the first optical area OA1 to secure transmittance. However, the cathode hole is not shown in FIG. 11.

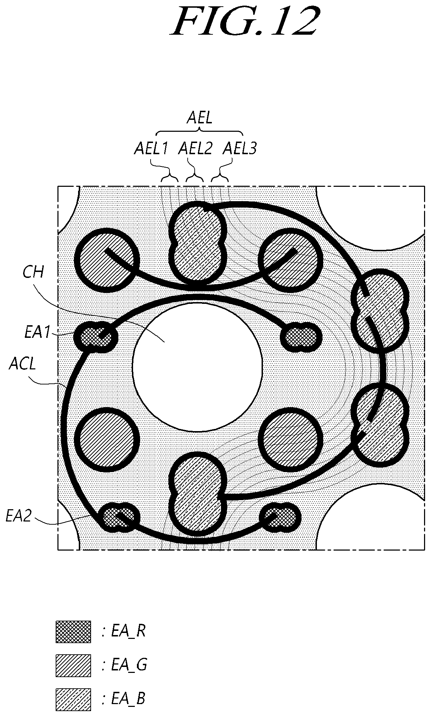

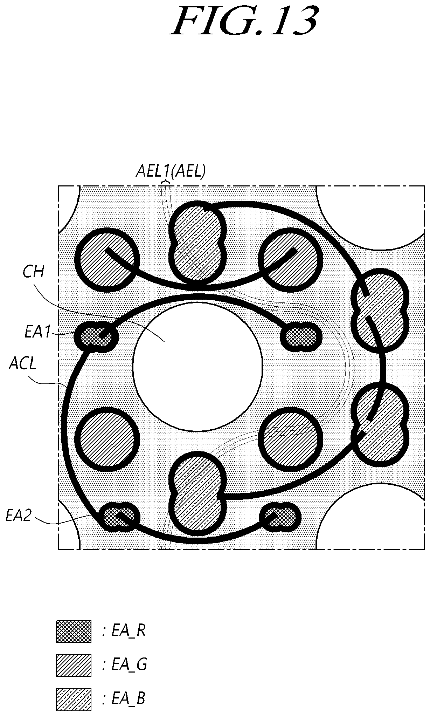

FIG. 12 and FIG. 13 are enlarged views of the first optical area OA1 of FIG. 11. More specifically, FIG. 12 is an enlarged view of a portion of row A6 of the first optical area OA1 of FIG. 11, and FIG. 13 is an enlarged view of a portion of row A8 of the first optical area OA1 of FIG. 11.

Referring to FIGS. 12 and 13, the anode extension line AEL may be positioned not to overlap the cathode hole CH. As the anode extension line AEL is positioned not to overlap the cathode hole CH, the display device may secure higher transmittance in the first optical area OA1. Further, since the anode extension line AEL may be positioned not to overlap the cathode hole CH but to overlap other opaque lines, the transmittance of the first optical area OA1 may be prevented from being reduced by the anode extension line AEL.

Comparison between FIGS. 12 and 13 reveals that the number of anode extension lines AEL is greater in the portion shown in FIG. 12 than in the portion shown in FIG. 13. FIG. 12 is an enlarged view of a portion of row A6 of the first optical area OA1 when referring to FIG. 11, and FIG. 13 is an enlarged view of a portion of row A8 of the first optical area OA1 when referring to FIG. 11. Given this difference, in FIG. 12, since the anode extension line AEL needs to connect a larger number of pixels PXL in the second direction D2, a larger number of anode extension lines AEL may be positioned in the portion shown in FIG. 12.

Referring to FIGS. 12 and 13, the shape of the anode extension line AEL may be a curved shape bypassing the cathode hole CH. When the anode extension line AEL bypasses the cathode hole CH, the anode extension line AEL does not overlap the cathode hole CH, so that the first optical area OA1 may have high transmittance as described above. Further, when the anode extension line AEL has a curved shape, flare may be suppressed from occurring when a camera positioned to overlap the first optical area OA1 is used as described above.

The cathode hole CH may have a circular shape. In this example, the shape of the anode extension line AEL may be an S shape bypassing the cathode hole CH. When the cathode hole CH has a circular shape and the anode extension line AEL has an S shape bypassing the cathode hole CH, the anode extension line AEL does not overlap the cathode hole CH but is positioned to overlap other opaque lines positioned not to overlap the cathode hole CH, so that the transmittance of the first optical area OA1 may be maximized. Further, since a space for positioning the anode extension line AEL may be effectively secured, a larger number of anode extension lines AEL may be disposed, so that the number of per-unit area pixels that the first optical area OA1 may have may increase.

In FIGS. 12 and 13, contact holes connecting the anode electrodes driving the emission areas EA_R, EA_G, and EA_B and the anode extension line AEL are not shown.

The display device may include a first emission area EA1, a second emission area EA2, and an anode connection line ACL. The first emission area EA1 and the second emission area EA2 may be positioned in the first optical area. The anode connection line ACL may connect the first emission area EA1 and the second emission area EA2. As the display device includes the anode connection line ACL, some EA1 and EA2 of the emission areas EA_R, EA_G, and EA_B positioned in the first optical area may be simultaneously driven through one anode connection line ACL so that the emission areas EA_R, EA_G, and EA_B positioned in the first optical area may be driven using fewer anode extension lines AEL. Thus, fewer subpixel circuit units may be disposed in the first optical bezel area, rendering it possible to reduce the thickness of the first optical bezel area. In this example, the first emission area EA1 and the second emission area EA2 may emit light of the same color. Emitting light of the same color may mean that they are the same when considering common errors that may occur between subpixels in the field of display technology.

The anode connection line ACL may be positioned not to overlap the cathode hole CH. The shape of the anode connection line ACL may be a curved shape bypassing the cathode hole CH. When the anode connection line ACL is positioned not to overlap the cathode hole CH but bypasses the cathode hole CH, transmittance of the first optical area may be maximized, so that the optical electronic device may effectively receive light. Further, when the anode connection line ACL has a curved shape, it is possible to suppress flare due to the anode connection line ACL when an optical electronic device, such as a camera, is used.

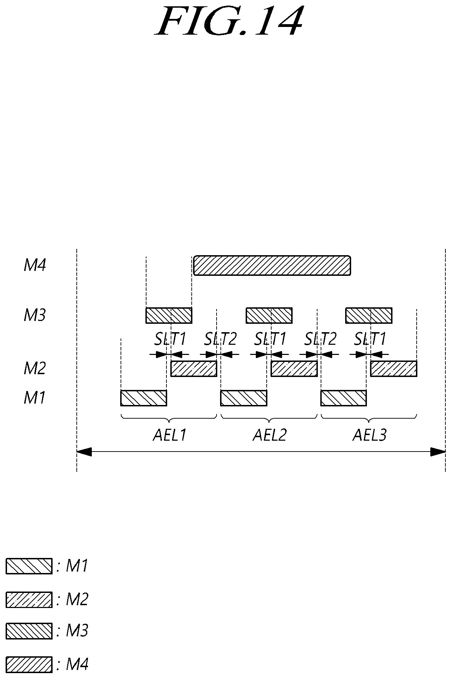

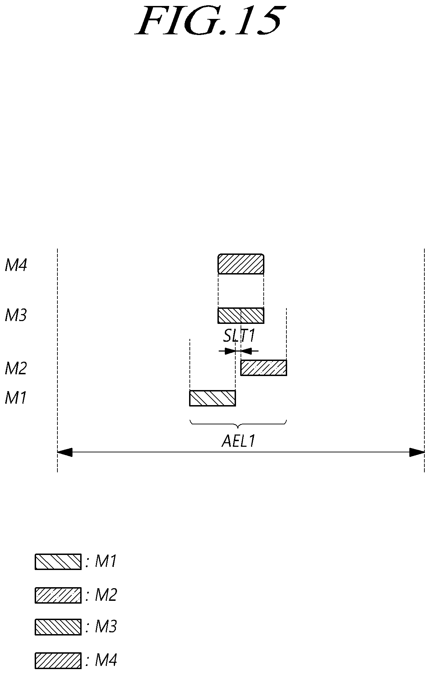

FIGS. 14 and 15 are views schematically illustrating a cross section of an anode extension line according to examples of the disclosure. More specifically, FIG. 14 illustrates a cross section of a first anode extension line AEL1, a second anode extension line AEL2, and a third anode extension line AEL3 included in the anode extension line AEL shown in FIG. 12, and FIG. 15 schematically illustrates a cross section of the first anode extension line AEL1 included in the anode extension line AEL shown in FIG. 13.

Referring to FIGS. 14 and 15, the first anode extension line AEL1 may include a first metal layer M1, a second metal layer M2 positioned on the first metal layer M1, and a third metal layer M3 positioned on the second metal layer M2.

The first metal layer M1 and the second metal layer M2 may be positioned not to overlap each other. As the first metal layer M1 and the second metal layer M2 are positioned not to overlap each other, unnecessary capacitance may be prevented from being formed in the display device. For example, the first metal layer M1 and the second metal layer M2 may be the two most adjacent metal layers that are positioned on different layers and have one or more insulation films positioned between the two layers. When the first metal layer M1 and the second metal layer M2, which are adjacent metal layers, are positioned to overlap each other, since the distance between the two layers is very short, a capacitance capable of deteriorating the display quality of the display device may be generated. However, in examples of the disclosure, as the first metal layer M1 and the second metal layer M2 are positioned not to overlap each other, degradation of display quality due to the capacitance between the first metal layer M1 and the second metal layer M2 may be prevented.

The first metal layer M1 and the second metal layer M2 may be positioned not to overlap each other, forming a first slit SLT1. In this example, the third metal layer M3 may be positioned to overlap the first slit SLT1. As the third metal layer M3 is positioned to overlap the first slit SLT1, haze defects caused by the first slit SLT1 may be effectively prevented.

The display device may further include a fourth metal layer M4. The fourth metal layer M4 may be a layer that does not constitute the anode extension lines AEL1, AEL2, and AEL3.

The first anode extension line AEL1 and the second anode extension line AEL2 may form a second slit SLT2. The second slit SLT2 may refer to a slit formed by the first metal layer M1 and the second metal layer M2 constituting the two adjacent anode extension lines AEL1 and AEL2. For example, the second slit SLT2 may refer to a slit formed by the second metal layer M2 constituting the first anode extension line AEL1 and the first metal layer M1 constituting the second anode extension line AEL2. The second slit SLT2 differs from the first slit SLT1 in that the first slit SLT1 is a slit formed by the metal layers M1 and M2 constituting one anode extension line AEL1, whereas the second slit SLT2 is a slit formed by the metal layers M1 and M2 constituting the two adjacent anode extension lines AEL1 and AEL2.

The fourth metal layer M4 may be positioned to overlap the second slit SLT2. As the fourth metal layer M4 is positioned to overlap the second slit SLT2, haze defects caused by the second slit SLT2 may be effectively prevented.

Further, the fourth metal layer M4 may be positioned to overlap the first slit SLT1. When not only the third metal layer M3 but also the fourth metal layer M4 is positioned to overlap the first slit SLT1, haze that may occur due to the first slit SLT1 may be more effectively prevented. In another example, the fourth metal layer M4 may cover all of the first to third metal layers M1, M2, and M3, preventing a parasitic capacitor between the first to third metal layers M1, M2, and M3 and the anode electrode AE.

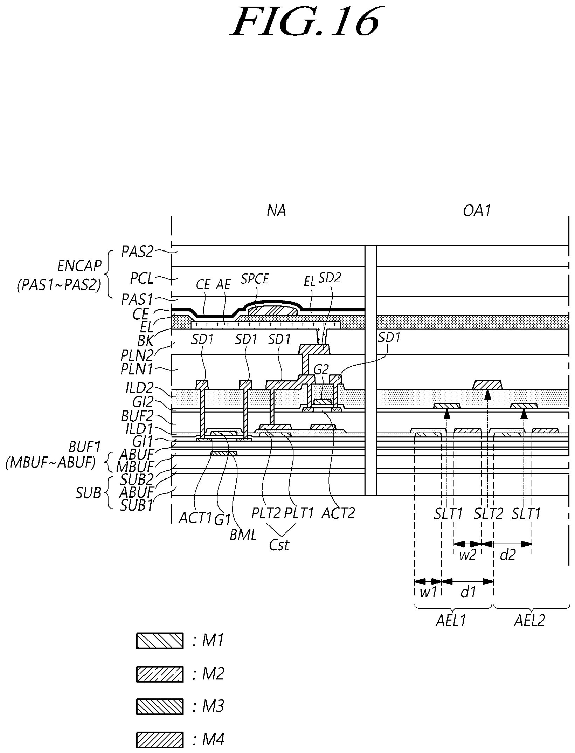

FIG. 16 is a cross-sectional view illustrating a display device according to examples of the disclosure. Hereinafter, in the description with reference to FIG. 16, matters not specifically described may be the same as those previously described with reference to FIGS. 8 and 9.

Referring to FIG. 16, the line width w1 of the first metal layer M1 constituting the anode extension line AEL in the first optical area OA1 may be identical to the line width w2 of the second metal layer M2 constituting the anode extension line AEL in the first optical area OA1.

For example, the line width w1 and the line width w2 may be minimum line widths determined considering process errors. When both the line width w1 and the line width w2 have the minimum line width, a larger number of anode extension lines AEL may be formed. Accordingly, since a large number of light emitting elements may be driven in the first optical area OA1, the display device may have excellent display quality in the first optical area OA1. In this example, both the line width w1 of the first metal layer M1 and the line width w2 of the second metal layer M2 are the minimum line widths that may be formed considering process errors, so they may be equal to each other.

The anode extension line may include a second anode extension line AEL2. The second anode extension line AEL2 may be positioned adjacent to the first anode extension line AEL1. The distance d1 between the first metal layer M1 of the first anode extension line AEL1 and the first metal layer M1 of the second anode extension line AEL2 may be the same as the distance d2 between the second metal layer M2 of the first anode extension line AEL1 and the second metal layer M2 of the second anode extension line AEL2.

For example, the distances d1 and d2 may be minimum distances determined considering process errors. When both the distance d1 and the distance d2 have the minimum distances, a larger number of anode extension lines AEL may be formed. Accordingly, since a large number of light emitting elements may be driven in the first optical area OA1, the display device may have excellent display quality in the first optical area OA1. In this example, since the distance d1 between the first metal layer M1 of the first anode extension line AEL1 and the first metal layer M1 of the second anode extension line AEL2 and the distance d2 between the second metal layer M2 of the first anode extension line AEL1 and the second metal layer M2 of the second anode extension line AEL2 are both minimum distances that may be formed considering process errors, the distance d1 and the distance d2 may be equal to each other.

The first source-drain electrode SD1 may be the first source electrode or the first drain electrode described above with reference to FIGS. 8 and 9. The second source-drain electrode SD2 may be the first relay electrode or the second relay electrode described above with reference to FIGS. 8 and 9.

The first metal layer M1 may be positioned on the same layer as the first gate electrode G1 and the first capacitor electrode PLT1. The second metal layer M2 may be positioned on the same layer as the second capacitor electrode PLT2. The third metal layer M3 may be positioned on the same layer as the second gate electrode G2. The fourth metal layer M4 may be positioned on the same layer as the first source-drain electrode SD1.

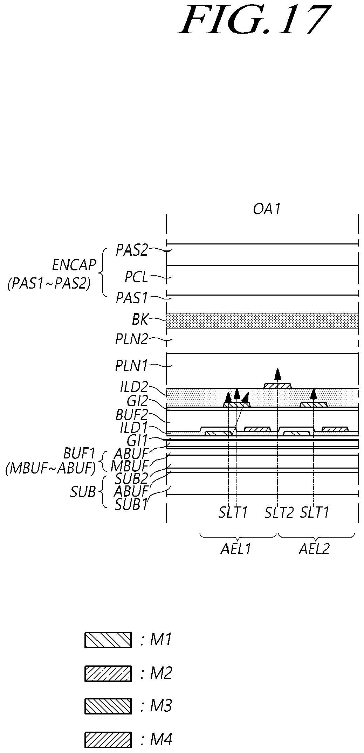

FIG. 17 is a cross-sectional view illustrating a display device according to examples of the disclosure. Hereinafter, in the description with reference to FIG. 17, matters not specifically described may be the same as those previously described with reference to FIGS. 8 and 9.

Referring to FIG. 17, the first metal layer M1, the second metal layer M2, the third metal layer M3, and the fourth metal layer M4 may be opaque. In other words, the first metal layer M1, the second metal layer M2, the third metal layer M3, and the fourth metal layer M4 constituting the anode extension lines AEL1 and AEL2 in the first optical area OA1 may be opaque. For example, the first metal layer M1, the second metal layer M2, the third metal layer M3, and the fourth metal layer M4, which are opaque, may be formed of the same material as the opaque metal layers constituting the thin film transistor array substrate.

When the first metal layer M1, the second metal layer M2, the third metal layer M3, and the fourth metal layer M4 are opaque, the first metal layer M1, the second metal layer M2, the third metal layer M3, and the fourth metal layer M4 may have higher electrical conductivity, so that efficiency of the display device may be enhanced.

Further, when the first metal layer M1, the second metal layer M2, the third metal layer M3, and the fourth metal layer M4 are opaque, the light transmitted through or diffracted by the slits SLT1 and SLT2 formed by adjacent metal layers may be effectively blocked by the third metal layer M3 and the fourth metal layer M4 so that the optical electronic device, such as a camera, positioned to overlap the first optical area OA1 may more smoothly receive light.

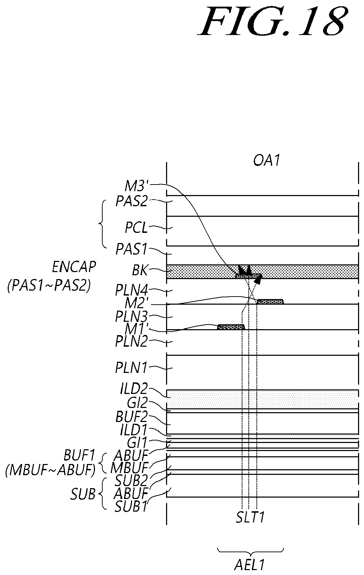

FIG. 18 is a cross-sectional view illustrating a display device according to examples of the disclosure. Hereinafter, in the description with reference to FIG. 18, matters not specifically described may be the same as those previously described with reference to FIGS. 8 and 9.

Referring to FIG. 18, the first metal layer M1', the second metal layer M2', and the third metal layer M3' may be transparent. In other words, the first metal layer M1', the second metal layer M2', and the third metal layer M3' constituting the anode extension lines AEL1 and AEL2 in the first optical area OA1 may be transparent. For example, the first metal layer M1', the second metal layer M2', and the third metal layer M3' which are transparent may be formed of the same material as the transparent conductive metal layer positioned over the thin film transistor array.

When the first metal layer M1', the second metal layer M2', and the third metal layer M3' are transparent, the first optical area OA1 may have a higher transmittance so that the optical electronic device positioned to overlap the first optical area OA1 may receive light more smoothly.

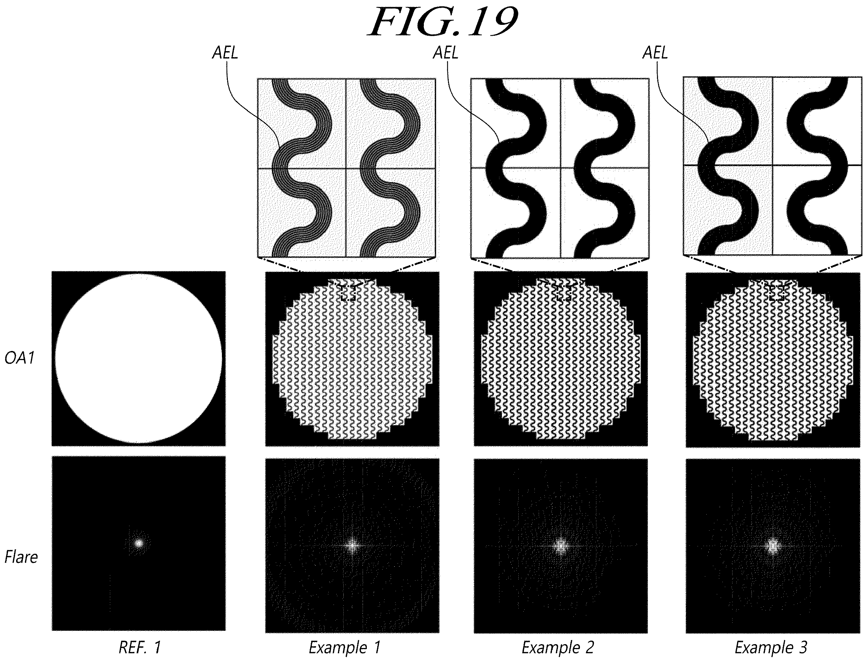

FIG. 19 is a view illustrating a flare suppression effect according to the shape of an anode extension line AEL according to examples of the disclosure.

Referring to FIG. 19, a display device according to examples of the disclosure may include anode extension lines AEL of various shapes. More specifically, example 1 is an example in which the metal layers forming the anode extension line AEL form a slit, example 2 is an example in which the slit formed by metal layers overlap another metal layer as described above in connection with FIGS. 14 to 18, and example 3 is an example in which the phase of some anode extension line patterns is reversed. REF. 1 is a comparative example in which only the camera hole is positioned in the first optical area OA1.

A look at the flare of examples 1 to 3 reveals that some flare occurs as compared with REF. 1, but no flare occurs in a specific direction. In other words, since the flare is overall symmetrical in shape although the anode extension line AEL in any one direction is positioned, it may be seen that it is possible to effectively prevent flare from being maximized in any one direction.

Specifically, both examples 1 and 2 exhibit excellent anti-flare effect, and example 3 in which the pattern phase is reversed has no significant difference from examples 1 and 2 in terms of anti-flare capability.

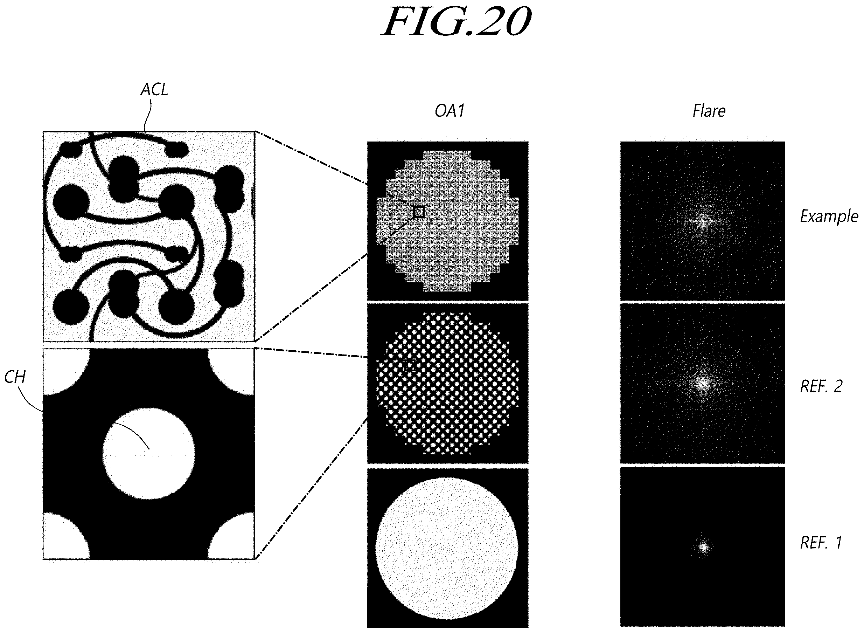

FIG. 20 is a view illustrating an anti-flare effect according to the shape of an anode extension line ACL according to a comparative example and example of the disclosure.

Referring to FIG. 20, REF. 1 is a comparative example in which the camera hole alone is positioned in the first optical area OA1, REF. 2 is a comparative example in which a plurality of cathode holes are positioned, and the example is an example in which the anode electrode and the anode connection line ACL are positioned.

In REF. 2, flare is observed that is not observed in REF. 1 due to the cathode hole pattern. In the example, the flare has been suppressed as compared to REF. 2. Accordingly, it may be identified that the display device including the curved anode connection line ACL according to examples of the disclosure suppresses flare.

Examples of the disclosure described above are briefly described below.

A display device 100 according to examples of the disclosure may comprise a display area DA, a cathode electrode CE, a first light emitting layer ED1, a first subpixel circuit unit SPC1, a first anode electrode AE1, and an anode extension line AEL.

The display area DA may include a first optical area OA1 and a first optical bezel area OBA1 positioned outside the first optical area OA1. The cathode electrode CE may include a plurality of cathode holes CH in the first optical area OA1. The first light emitting element ED1 may be positioned in the first optical area OA1 and may include a first anode electrode AE1. The first subpixel circuit unit SPC1 may be positioned in the first optical bezel area OBA1. The anode extension line AEL may electrically connect the first subpixel circuit unit SPC1 and the first anode electrode AE1 and be positioned not to overlap a cathode hole CH. The anode extension line AEL may have a curved shape.

The anode extension line AEL may have a curved shape bypassing the cathode hole CH.

The cathode hole CH may have a circular shape. Further, the anode extension line AEL may have an S shape bypassing the cathode hole CH.

The display device 100 includes a first emission area EA1 positioned in a first optical area OA1, a second emission area EA2 positioned in the first optical area OA1, and an anode connection line ACL connecting the first emission area EA1 and the second emission area EA2. The first emission area EA1 and the second emission area EA2 may emit light of the same color. The anode connection line ACL may be positioned not to overlap the cathode hole CH, and the anode connection line ACL may have a curved shape bypassing the cathode hole CH.

The anode extension line AEL may include a first anode extension line AEL1. The first anode extension line AEL1 may include a first metal layer M1, a second metal layer M2 positioned on the first metal layer M1, and a third metal layer M3 positioned on the second metal layer M2. The first metal layer M1 and the second metal layer M2 may be positioned not to overlap each other, forming a first slit SLT1. The third metal layer M3 may be positioned to overlap the first slit SLT1. The display device 100 may further include a fourth metal layer M4. The first metal layer M1 and the second metal layer M2 may be positioned not to overlap each other to form the second slit SLT2, and the fourth metal layer M4 may be positioned to overlap the second slit SLT2. A line width w1 of the first metal layer M1 and a line width w2 of the second metal layer M2 may be equal to each other.

The anode extension line AEL may include a second anode extension line AEL2. The second anode extension line AEL2 may include a first metal layer M1, a second metal layer M2, and a third metal layer M3. The second anode extension line AEL2 may be positioned adjacent to the first anode extension line AEL1.

The distance d1 between the first metal layer M1 of the first anode extension line AEL1 and the first metal layer M1 of the second anode extension line AEL2 may be the same as the distance d2 between the second metal layer M2 of the first anode extension line AEL1 and the second metal layer M2 of the second anode extension line AEL2.

The first metal layer M1, the second metal layer M2, the third metal layer M3, and the fourth metal layer M4 may be opaque.

The first metal layer M1, the second metal layer M2, and the third metal layer M3 may be transparent.

The above description has been presented to enable any person skilled in the art to make and use the technical idea of the disclosure, and has been provided in the context of a particular application and its requirements. Various modifications, additions and substitutions to the described examples will be readily apparent to those skilled in the art, and the general principles defined herein may be applied to other examples and applications, provided they remain within the scope of the appended claims. The above description and the accompanying drawings provide an example of the technical idea of the disclosure for illustrative purposes only. Also disclosed herein are a number of examples, according to the following numbered clauses.
Clause 1. A display device, comprising:
   a display area including a first optical area and a first optical bezel area positioned outside the first optical area;
   a cathode electrode including a plurality of cathode holes in the first optical area;
   a first light emitting element positioned in the first optical area and including a first anode electrode;
   a first subpixel circuit unit positioned in the first optical bezel area; and
   an anode extension line electrically connecting the first subpixel circuit unit and the first anode electrode and positioned not to overlap the cathode hole, wherein the anode extension line has a curved shape.
Clause 1A. A display device (100), comprising:
   a display area (DA) including a first optical area (OA1) and a first optical bezel area (OBA1) positioned outside the first optical area;
   a first light emitting element (ED1) positioned in the first optical area and including a first anode electrode (AE1);
   a first subpixel circuit unit (SPC1) positioned in the first optical bezel area; and
   an anode extension line (AEL) electrically connecting the first subpixel circuit unit and the first anode electrode and positioned not to overlap the cathode hole, wherein the anode extension line has a curved shape.
Clause 2. The display device of clause 1 or clause 1A, wherein the anode extension line has the curved shape bypassing the cathode hole.
Clause 3. The display device of any preceding clause, wherein the cathode hole has a circular shape, and wherein the anode extension line has an S shape bypassing the cathode hole.
Clause 4. The display device of any preceding clause, further comprising:
   a first emission area positioned in the first optical area;
   a second emission area positioned in the first optical area; and
   an anode connection line connecting the first emission area and the second emission area.
Clause 5. The display device of any preceding clause, wherein the first emission area and the second emission area emit light of the same color.
Clause 6. The display device of any preceding clause, wherein the anode connection line is positioned not to overlap the cathode hole, and wherein the anode connection line has a curved shape bypassing the cathode hole.
Clause 7. The display device of any preceding clause, wherein the anode extension line includes a first anode extension line including a first metal layer, a second metal layer positioned on the first metal layer, and a third metal layer positioned on the second metal layer,
   wherein the first metal layer and the second metal layer are positioned not to overlap each other to form a first slit, and
   wherein the third metal layer is positioned to overlap the first slit.
Clause 8. The display device of clause 7, wherein the anode extension line further includes a second anode extension line including the first metal layer, the second metal layer, and the third metal layer and positioned adjacent to the first anode extension line,
   wherein a fourth metal layer is disposed on the first anode extension line and the second anode extension line,
   wherein the first anode extension line and the second anode extension line are positioned not to overlap each other to form a second slit, and
   wherein the fourth metal layer is positioned to overlap the second slit.
Clause 9. The display device of clause 7 or clause 8, wherein a line width of the first metal layer and a line width of the second metal layer are equal to each other.
Clause 10. The display device according to any of clauses 7 to 9, wherein the anode extension line further includes a second anode extension line including the first metal layer, the second metal layer, and the third metal layer and positioned adjacent to the first anode extension line, and
   wherein a distance between the first metal layer of the first anode extension line and the first metal layer of the second anode extension line is equal to a distance between the second metal layer of the first anode extension line and the second metal layer of the second anode extension line.
Clause 11. The display device of clause 8, wherein the first metal layer, the second metal layer, the third metal layer, and the fourth metal layer are opaque.
Clause 12. The display device according to any of clauses 7 to 11, wherein the first metal layer, the second metal layer, and the third metal layer are transparent.
Clause 13. The display device of any preceding clause, wherein the first light emitting element comprises an emission area which is arranged not to overlap with any of the cathode holes.
Clause 14. The display device of any preceding clause, comprising a plurality of first light emitting elements positioned in the first optical area, each including a respective first anode electrode, the display device further comprising a plurality of first subpixel circuit units, wherein each of the first subpixel circuit units is configured to drive a respective first light emitting element and is positioned in the first optical bezel area.
Clause 15. The display device of clause 14, wherein at least one of the first subpixel circuit units drives at least two of the first light emitting elements.
Clause 16. The display device according to clause 14, further comprising a plurality of anode extension lines, each anode extension line connecting a first light emitting element of the plurality of first light emitting elements to a respective one of the first subpixel circuits units, wherein each anode extension line is curved, and wherein none of the anode extension lines overlap with any of the cathode holes. Clause 17. The display device according to clause 16, wherein a density of the anode extension lines is greater at an edge of the first optical area than it is at a center of the first optical area.
Clause 18. The display device according to any preceding clause, wherein the cathode holes are circular.
Clause 19. The display device according to any preceding clause, wherein the first optical area is circular.
Clause 20. The display device according to claim 19, wherein the first optical bezel area is an annular area surrounding the first optical area.

## Claims

1. A display device (100), comprising:
a display area (DA) including a first optical area (OA1) and a first optical bezel area (OBA1) positioned outside the first optical area;
a cathode electrode (CE), the cathode electrode including a plurality of cathode holes (CH) in the first optical area;
a first light emitting element (ED1) positioned in the first optical area and including a first anode electrode (AE1);
a first subpixel circuit unit (SPC1) positioned in the first optical bezel area; and
an anode extension line (AEL) electrically connecting the first subpixel circuit unit and the first anode electrode and positioned not to overlap the cathode hole, wherein the anode extension line has a curved shape.

2. The display device of claim 1, wherein the anode extension line has the curved shape bypassing the cathode hole.

3. The display device of claim 1 or claim 2, wherein the cathode hole has a circular shape, and wherein the anode extension line has an S shape bypassing the cathode hole.

4. The display device of any preceding claim, further comprising:
a first emission area (EA1) positioned in the first optical area;
a second emission area (EA2) positioned in the first optical area; and
an anode connection line (ACL) connecting the first emission area and the second emission area.

5. The display device of claim 4, wherein the first emission area and the second emission area emit light of the same color.

6. The display device of claim 4 or claim 5, wherein the anode connection line is positioned not to overlap the cathode hole, and wherein the anode connection line has a curved shape bypassing the cathode hole.

7. The display device of any preceding claim, wherein the anode extension line includes a first anode extension line (AEL1) including a first metal layer (ML1), a second metal layer (ML2) positioned on the first metal layer, and a third metal layer (ML3) positioned on the second metal layer,
wherein the first metal layer and the second metal layer are positioned not to overlap each other to form a first slit therebetween, and
wherein the third metal layer is positioned to overlap the first slit.

8. The display device of claim 7, wherein the anode extension line further includes a second anode extension line (AEL2) including the first metal layer, the second metal layer, and the third metal layer and positioned adjacent to the first anode extension line,
wherein a fourth metal layer (ML4) is disposed on the first anode extension line and the second anode extension line,
wherein the first anode extension line and the second anode extension line are positioned not to overlap each other to form a second slit therebetween, and
wherein the fourth metal layer is positioned to overlap the second slit.

9. The display device of claim 7 or claim 8, wherein a line width of the first metal layer and a line width of the second metal layer are equal to each other.

10. The display device according to claim 7, wherein the anode extension line further includes a second anode extension line (AEL2) including the first metal layer, the second metal layer, and the third metal layer and positioned adjacent to the first anode extension line, and
wherein a distance between the first metal layer of the first anode extension line and the first metal layer of the second anode extension line is equal to a distance between the second metal layer of the first anode extension line and the second metal layer of the second anode extension line.

11. The display device of claim 8, wherein the first metal layer, the second metal layer, the third metal layer, and the fourth metal layer are opaque.

12. The display device according to any of claims 7 to 10, wherein the first metal layer, the second metal layer, and the third metal layer are transparent.

13. The display device according to any preceding claim, wherein a number of anode extension lines per unit area decreases from an edge of the first optical area to a centre of the first optical area.

14. The display device of any preceding claim, further comprising a normal area (NA) surrounding the first optical bezel area, optionally wherein the first optical area has a higher light transmittance than the normal area and the first optical bezel area.

15. The display device of any preceding claim, wherein the plurality of anode extension lines are divided into a plurality of groups, and the thickness of each of the plurality of groups decreases from an edge of the first optical area to a centre of the first optical area.
